Europäisches Patentamt

European Patent Office

Office européen des brevets

(19)

(11) **EP 0 984 577 B1**

(12) **EUROPEAN PATENT SPECIFICATION**

(45) Date of publication and mention
of the grant of the patent:
**22.12.2004 Bulletin 2004/52**

(51) Int Cl.⁷: **H04J 13/00**, G06F 7/58

(21) Application number: **99122091.4**

(22) Date of filing: **27.06.1996**

(54) **A code sequence generator apparatus for a CDMA modem**

Eine Kodesequenz-Generatorvorrichtung für ein CDMA modem

Dispositif générateur d'un code d'étalement pour un modem de AMRC

(84) Designated Contracting States:
**AT BE CH DE DK ES FI FR GB GR IE IT LI LU MC NL PT SE**

(30) Priority: **30.06.1995 US 775 P**

(43) Date of publication of application:
**08.03.2000 Bulletin 2000/10**

(62) Document number(s) of the earlier application(s) in accordance with Art. 76 EPC:
**96923525.8 / 0 835 568**

(73) Proprietor: **INTERDIGITAL TECHNOLOGY CORPORATION**
**Wilmington, DE 19801 (US)**

(72) Inventors:
• **Lomp, Gary**
**Centerpot, New York 11721 (US)**
• **Fatih, Ozluturk**
**Port Washington, NY 11050 (US)**
• **Silverberg, Avi**
**Commack, New York 11725 (US)**

(74) Representative: **Frohwitter, Bernhard, Dipl.-Ing.**
**Patent- und Rechtsanwälte,**
**Possartstrasse 20**
**81679 München (DE)**

(56) References cited:
**WO-A-93/14588          US-A- 4 320 513**
**US-A- 5 365 585**

EP 0 984 577 B1

**Description**

BACKGROUND OF THE INVENTION

Providing quality telecommunication services to user groups which are classified as remote, such as rural telephone systems and telephone systems in underdeveloped countries, has proved to be a challenge over recent years. The past needs created by these services have been partially satisfied by wireless radio services, such as fixed or mobile frequency division multiplex (FDM), frequency division multiple access (FDMA), time division multiplex (TDM), time division multiple access (TDMA) systems, combination frequency and time division systems (FD/TDMA), and other land mobile radio systems.Often, these remote services are faced with more potential users than can be supported simultaneously by their frequency or spectral bandwidth capacity.

Recognizing these limitations, recent advances in wireless communications have used spread spectrum modulation techniques to provide simultaneous communication by multiple users. Spread spectrum modulation refers to modulating a information signal with a spreading code signal; the spreading code signal being generated by a code generator where the period Tc of the spreading code is substantially less than the period of the information data bit or symbol signal. The code may modulate the carrier frequency upon which the information has been sent, called frequency-hopped spreading, or may directly modulate the signal by multiplying the spreading code with the information data signal, called direct-sequence spreading (DS). Spread-spectrum modulation produces a signal with bandwidth substantially greater than that required to transmit the information signal, and synchronous reception and despreading of the signal at the receiver demodulator recovers the original information. The synchronous demodulator uses a reference signal to synchronize the despreading circuits to the input spread-spectrum modulated signal in order to recover the carrier and information signals. The reference signal can be a spreading code which is not modulated by an information signal.

Spread-spectrum modulation in wireless networks offers many advantages because multiple users may use the same frequency band with minimal interference to each user's receiver. Spread-spectrum modulation also reduces effects from other sources of interference. In addition, synchronous spread-spectrum modulation and demodulation techniques may be expanded by providing multiple message channels for a user, each spread with a different spreading code, while still transmitting only a single reference signal to the user.

One area in which spread-spectrum techniques are used is in the field of mobile cellular communications to provide personal communication services (PCS). Such systems desirably support large numbers of users, control Doppler shift and fade, and provide high speed digital data signals with low bit error rates. These systems employ a family of orthogonal or quasi-orthogonal spreading codes, with a pilot spreading code sequence synchronized to the family of codes. Each user is assigned one of the spreading codes as a spreading function. Related problems of such a system are: supporting a large number of users with the orthogonal codes, handling reduced power available to remote units, and handling multipath fading effects. Solutions to such problems include using phased-array antennas to generate multiple steerable beams, using very long orthogonal or quasi-orthogonal code sequences which are reused by cyclic shifting of the code synchronized to a central reference, and diversity combining of multipath signals. JP 7-86982 describes an asynchronous pseudo-noise (PN) code sequence generating circuit which generates a plurality of PN code sequences. A feedback type PN code generator generates a master PN code sequence and code converters for each of N channels convert the master PN sequence to a PN code sequence in accordance with a mask pattern. The mask patterns for each channel are stored in the corresponding mask memory.

SUMMARY OF THE INVENTION

The present invention provides a code sequence generator apparatus according to claim 1. Further preferred aspects are provided according to the dependent claims.

In accordance with the present invention, a code sequence generator apparatus generates a plurality of spreading code sequences including a master spreading code sequence. The spreading code sequences having mutual cross correlation within a range, and a mutual code phase relationship. A linear feedback shift register (LFSR) provides tap signals to logic circuitry which in turn produces a feedback spreading code signal, applied to a first stage of the LFSR. The LFSR responds to a sequence of spreading-code sequence bit values. The LFSR sequentially transfers each of a plurality of tap signals from one stage to the next stage and for transfers the feedback spreading code value to the first stage, and each successive one of the tap values of the last stage defines the master spreading code sequence. A second memory responds to a clock signal for providing a repetitive even code sequence having a cross correlation with the master spreading sequence which is within a predetermined range and has an even number of chip spreading values. A plurality of cascade connected feedforward circuits receive the master spreading code sequence and provide a plurality of distinct code sequences. A plurality of code sequence combiners combine respective spreading code sequence with said even code sequence to produce a plurality of relatively long spreading code sequences, with each long spreading code sequence having a greater number of elements than any one of the plurality of spreading code sequences.

To generate large families of nearly mutually orthogonal codes used by the CDMA modems, the exemplary modem includes a code sequence generator. The code sequences are assigned to a respective logical channel of the spread-spectrum communication system, which includes In-phase (I) and Quadrature (Q) transmission over RF communication channels. One set of sequences is used as pilot sequences that are transmitted without being modulated by a data signal. The code sequence generator circuit includes a long code sequence generator including a linear feedback shift register, a memory which provides a short, even code sequence, and a plurality of cyclic shift, feedforward sections, each of which provides a respective code sequence in the family of code sequences. The code sequence generator further includes a group of code sequence combiners for combining each generated code sequence with the short, even code sequence to produce a group, or family, of long code sequences having relatively low mutual correlation.

BRIEF DESCRIPTION OF THE DRAWINGS

Figure 1 is a block diagram of a code division multiple access communication system according to the present invention.

Figure 2a is a block diagram of a 36 stage linear shift register suitable for use with long spreadingcode of the code generator of the present invention.

Figure 2b is a block diagram of circuitry which illustrates the feed-forward operation of the code generator.

Figure 2c is a block diagram of an exemplary code generator of the present invention including the circuit for generating spreadingcode sequences from the, long spreadingcode and the short spreadingcodes.

Figure 2d is an alternate embodiment of the code generator circuit including delays to compensate for electrical circuit delays.

Figure 3a is a graph of the constellation points of the pilot spreadingcode QPSK signal.

Figure 3b is a graph of the constellation points of the message channel QPSK signal.

Figure 3c is a block diagram of exemplary circuitry which implements the method of tracking the received spreadingcode phase of the present invention.

DESCRIPTION OF THE EXEMPLARY EMBODIMENT

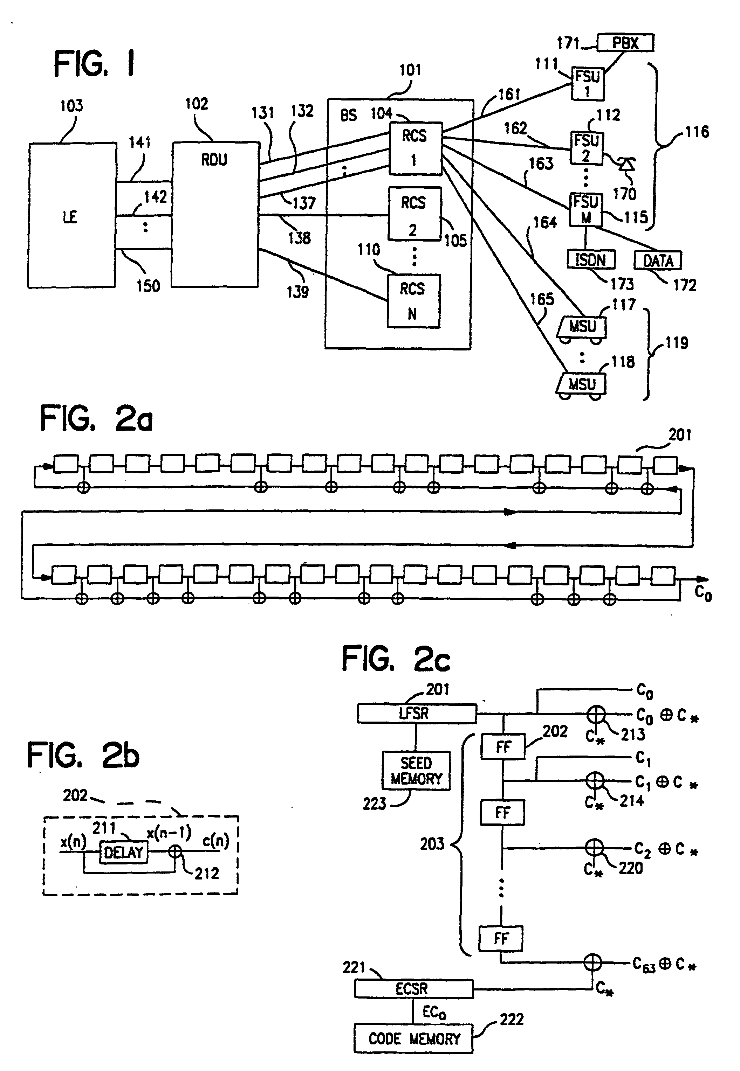

An exemplary system which includes a modem according to the present invention provides local-loop telephone service using radio link between one or more base stations and multiple remote subscriber units. In the exemplary embodiment, the radio link is described for a base station communicating with a fixed subscriber unit (FSU), but the system is equally applicable to systems including multiple base stations with radio links to both FSUs and Mobile Subscriber Units (MSUs). Consequently, the remote subscriber units are referred to herein as Subscriber Units (SUs). Referring to Figure 1, in the exemplary system, the Base Station (BS) 101 provides call connection to the local exchange (LE) 103 or other and telephone network switching interface, and includes the Radio Carrier Station RCS (104). One or more RCSs 104, 105, 110 connect to the Radio Distribution Unit (RDU) 102 through the links 131, 132, 137, 138, 139, and the RDU 102 in turn interfaces with the LE 103 by transmitting and receiving call set-up, control, and information signals through telco links 141, 142, 150. The SUs 116, 119 communicate with the RCS 104 through radio links 161, 162, 163, 164, 165. Both the RCS and the SUs include CDMA modems which establish and maintain the radio links. Alternatively, another embodiment of the invention may include several SUs and a "master" SU which functions in much the same was as the RCS to allow communication among the SUs. Such embodiment may or may not have connection to a local telephone network.

Although the described embodiment uses different spread-spectrum bandwidths centered around a carrier for the transmit and receive spread-spectrum channels, the present method is readily extended to systems using multiple spread-spectrum bandwidths for the transmit channels and multiple spread-spectrum bandwidths for the receive channels. Alternatively, because spread-spectrum communication systems have the inherent feature that one user's transmission appears as noise to another user's despreading receiver, an embodiment can employ the same spread-spectrum channel for both the transmit and receive path channels. In other words, Uplink and Downlink transmissions can occupy the same frequency band.

The spread binary symbol information is transmitted over the radio links 161 to 165 using Quadrature Phase Shift Keying (QPSK) modulation with Nyquist Pulse Shaping in the present embodiment, although other modulation techniques may be used, including, but not limited to, Offset QPSK (OQPSK) and Minimum Shift Keying (MSK).

The RCS and the SUs each contain CDMA modems according to the present invention for transmission and reception of telecommunication signals including information signals and connection control signals. A CDMA modem which includes an embodiment of the present invention includes a modem transmitter having: a code generator which provides an associated pilot code signal and which generates a plurality of message code signals; a spreading circuit which combines each of the information signals, with a respective one of the message code signals to generate a spread-spectrum processed message signal; and a global pilot code generator that provides a global pilot code signal to which the message code signals are synchronized.

The exemplary CDMA modem also includes a modem receiver having associated pilot code acquisition and tracking logic. The associated pilot code acquisition logic includes an associated pilot code generator and a group of associated pilot code correlators for correlating code-phase delayed versions of the associated pilot signal with a receive CDM signal to produce a despread associated pilot signal. The code phase of the associated pilot signal is changed responsive to an acquisition signal value until a detector indicates the presence of the despread associated pilot code signal by changing the value of the acquisition signal. The associated pilot code signal is synchronized to the global pilot signal. The associated pilot code tracking logic adjusts the associated pilot code signal in phase responsive to the acquisition signal so that the signal power level of the despread associated pilot code signal is maximized. Finally, the CDMA modem receiver includes a group of message signal acquisition circuits. Each message signal acquisition circuit includes a plurality of receive message signal correlators which correlate the local received message code signal with the CDM signal to produce a respective despread received message signal.

Referring to Fig. 1, the radio links 161 to 165 incorporate Broadband Code Division Multiple Access (B-CDMA™) as the mode of transmission in both the Uplink and Downlink directions. CDMA (also known as Spread Spectrum) communication techniques used in multiple access systems are well-known. The described exemplary system uses the Direct Sequence (DS) spreading technique. In each modem, one or more CDMA modulators performs the spread-spectrum spreading code sequence generationIn addition, the modems generate, for example, a pseudonoise (PN) spreading sequence; and peform complex DS modulation to produce quadrature phase shift keying (QPSK) signals for the In-phase (I) and Quadrature (Q) channels. Pilot signals are generated and transmitted with the modulated signals. The pilot signals of the present embodiment are spreading codes which are not modulated by data. The pilot signals are used for system synchronization, carrier phase recovery, and for estimating the impulse response of the radio channel. Each SU includes a single pilot generator and at least one CDMA modulator and demodulator, called a CDMA modem. Each RCS 104, 105, 110 has a single pilot generator plus sufficient CDMA modulators and demodulators for all the logical channels in use by all SUs.

The CDMA demodulator despreads the signal, with appropriate processing to combat or exploit multipath propagation effects. Parameters concerning the received power level are used to generate the Automatic Power Control (APC) information which, in turn, is transmitted to the other end (i.e. from the SU to the RCS or from the RCS to the SU). The APC information is used to control transmit power of the automatic forward power control (AFPC) and automatic reverse power control (ARPC) links. In addition, each RCS 104, 105 and 110 may perform Maintenance Power Control (MPC), in a manner similar to APC, to adjust the initial transmit power of each SU 111, 112, 115, 117 and 118.

Diversity combining at the radio antennas of the RCS 104, 105 and 110 is not necessary because CDMA has inherent frequency diversity due to the spread bandwidth. Receivers may include Adaptive Matched Filters (AMFs) (not shown in Figure 1), however, which combine the multipath signals. In the exemplary embodiment, AMFs perform Maximal Ratio Combining.

## Logical Communication Channels

A 'channel' of the prior art is usually regarded as a communications path which is part of an interface and which can be distinguished from other paths of that interface without regard to its content. In the case of CDMA, however, separate communications paths are distinguished only by their content. The term 'logical channel' is used to distinguish the separate data streams, which are logically equivalent to channels in the conventional sense. All logical channels and sub-channels of the present invention are mapped to a common 64 kilo-symbols per second (ksym/s) QPSK stream. Some channels are synchronized to associated pilot codes which are generated in the same way and perform much the same function as the system Global Pilot Code. The system pilot signals are not, however, considered logical channels.

Several logical communication channels are used over the RF communication link between the RCS and SU.

Each logical communication channel has either a fixed, pre-determined spreading code or a dynamically assigned spreading code. For both pre-determined and assigned codes, the code phase is in synchronism with the Pilot Code. Logical communication channels are divided into two groups: the Global Channel (GC) group includes those channels which are either transmitted from the base station RCS to all the remote SUs or from any SU to the RCS of the base station regardless of the SU's identity, These channels contain for all users and include the channels used by SUs to gain access to message communication channels. Channels in the Assigned Channels (AC) group are those channels which are dedicated to communication between the RCS and a particular SU.

The Global Channels (GC) group provides for 1) Broadcast logical channels, which provide point to multipoint services for broadcasting messages to all SUs and paging messages to SUs; and 2) Access Control logical channels which provide point to-point services on global channels for SUs to access the system and obtain assigned channels.

An Assigned Channel (AC) group contains the logical channels that control a single telecommunication connection between the RCS and a SU. The functions developed when an AC group is formed consists of a pair of power control logical message channels for each of the Uplink and Downlink connections, and depending on the type of connection, one or more pairs of traffic channels. The Bearer Control function performs the required forward error control, bearer rate modification, and encryption functions. The logical channels which constitute the BC and AC groups are summarized below in Table 1.

Table 1:

| Logical Channels and sub-channels of the B-CDMA Air Interface | | | | | | | |
|---|---|---|---|---|---|---|---|
| Channel name | Abbr. | Brief Description | Direction (forward or reverse) | Bit rate | Max BER | Power level | Pilot |
| Global Channels | | | | | | | |
| Fast Broadcast Channel | FBCH | Broadcasts fast-changing system information | F | 16 kbit/ s | 1e-4 | Fixed | GLPT |
| Slow Broadcast Channel | SBCH | Broadcasts paging messages to FSUs and slow-changing system information | F | 16 kbit/ s | 1e-7 | Fixed | GLPT |
| Access Channels | AXCH(i) | For initial access attempts by FSUs | R | 32 kbit/ s | 1e-7 | Controlled by APC | LAXPT (i) |
| Control Channels | CTCH(i) | For granting access | F | 32 kbit/ s | 1e-7 | Fixed | GLPT |
| Assigned Channels | | | | | | | |
| 16 kbit/s POTS | TRCH /16 | General POTS use | F/R | 16 kbit/ s | 1e-4 | Controlled by APC | F-GLPT R-ASPT |
| 32 kbit/s POTS | TRCH /32 | General POTS use | F/R | 32 kbit/ s | 1e-4 | Controlled by APC | F-GLPT R-ASPT |
| 64 kbit/s POTS | TRCH /64N | POTS use for in-band modems/ fax | F/R | 64 kbit/ s | 1e-4 | Controlled by APC | F-GLPT R-ASPT |

Table 1:   (continued)

| Logical Channels and sub-channels of the B-CDMA Air Interface | | | | | | | |
|---|---|---|---|---|---|---|---|
| Channel name | Abbr. | Brief Description | Direction (forward or reverse) | Bit rate | Max BER | Power level | Pilot |
| Assigned Channels | | | | | | | |
| Traffic channel @ 64 kbit/ s-low BER | TRCH /64L | ISDN B channel or LL | F/R | 64 kbit/ s | 1e-7 | Controlled by APC | F-GLPT R-ASPT |
| D channel | TRCH /16L | ISDN D channel | F/R | 16 kbit/ s | 1e-7 | Controlled by APC | F-GLPT R-ASPT |
| Order wire channel | OW | assigned signaling channel | F/R | 32 kbit/ s | 1e-7 | Controlled by APC | F-GLPT R-ASPT |
| APC channel | APC | carries APC commands | F/R | 64 kbit/ s | 2e-1 | Controlled by APC | F-GLPT R-ASPT |

The APC data is sent at 64 kbit/sec. The APC logical channel is not FEC coded to avoid delay and is transmitted at a low power level to minimize capacity used for APC. Alternatively, the APC and order wire (OW) data may be separately modulated using complex spreading code sequences, or they may be time division multiplexed with a 16 kbit/s traffic channel.

**The Spreading Codes**

The CDMA code generators used to encode the logical channels of the present invention employ Linear Shift Registers (LSRs) with feedback logic which is a method well known in the art. The code generators of the present embodiment of the invention generate 64 synchronous unique sequences. Each RF communication channel uses a pair of these sequences for complex spreading (in-phase and quadrature) of the logical channels, so the generator gives 32 complex spreading sequences. The sequences are generated by a single seed which is initially loaded into a shift register circuit.

**The Generation of Spreading Code Sequences and Seed Selection**

The spreading code period of the present invention is defined as an integer multiple of the symbol duration, and the beginning of the code period is also the beginning of the symbol. The relation between bandwidths and the symbol lengths chosen for the exemplary embodiment of the present invention is:

| BW(MHZ) | L(chips/ symbol) |
|---|---|
| 7 | 91 |
| 10 | 130 |
| 10.5 | 133 |
| 14 | 182 |
| 15 | 195 |

The spreading code length is also a multiple of 64 and of 96 for ISDN frame support. The spreading code is a sequence of symbols, called chips or chip values. The general methods of generating pseudorandom sequences using Galois Field mathematics is known to those skilled in the art; hoever, the inventor has derived a unique set, or family, of code sequences for the present invention. First, the length of the linear feedback shift register to generate a code sequence is chosen, and the initial value of the register is called a "seed". Second, the constraint is imposed that no code sequence generated by a code seed can be a cyclic shift of another code sequence generated by the same code seed. Finally, no code sequence generated from one seed can be a cyclic shift of a code sequence generated by another seed.

The inventor has determined that the spreading code length of chip values of the present invention is:

$$128 \times 233415 = 29877120 \qquad (1)$$

The spreading codes are generated by combining a linear sequence of period 233415 and a nonlinear sequence of period 128

The nonlinear sequence of length 128 is implemented as a fixed sequence loaded into a shift register with a feed-back connection. The fixed sequence can be generated by an m-sequence of length 127 padded with an extra logic 0, 1, or random value as is well known in the art.

The linear sequence of length L=233415 is generated using a linear feedback shift register (LFSR) circuit with 36 stages. The feedback connections correspond to a irreducible polynomial h(n) of degree 36. The polynomial h(x) chosen by the inventor for the exemplary embodiment of the present invention is

$$h(x) = x^{36} + x^{35} + x^{30} + x^{28} + x^{26} + x^{25} + x^{22} + x^{20} + x^{19} + x^{17}$$

$$+ x^{16} + x^{15} + x^{14} + x^{12} + x^{11} + x^{9} + x^{8} + x^{4} + x^{3} + x^{2} + 1 \qquad (2)$$

A group of "seed" values for a LFSR representing the polynomial h(x) of equation (2) which generates code sequences that are nearly orthogonal with each other is determined. The first requirement of the seed values is that the seed values do not generate two code sequences which are simply cyclic shifts of each other.

The present invention includes a method to increase the number of available seeds for use in a CDMA communication system by recognizing that certain cyclic shifts of the previously determined code sequences may be used simultaneously. The round trip delay for the cell sizes and bandwidths of the present invention are less than 3000 chips. In one embodiment of the present invention, sufficiently separated cyclic shifts of a sequence can be used within the same cell without causing ambiguity for a receiver attempting to determine the code sequence. This method enlarges the set of sequences available for use.

By implementing the tests previously described, a total of 3879 primary seeds were determined by the inventor through numerical computation. These seeds are given mathematically as

$$d^{n} \text{ modulo } h(x) \qquad (3)$$

where 3879 values of n are listed in the appendix, with d = (00,...00111).

When all primary seeds are known, all secondary seeds of the present invention are derived from the primary seeds by shifting them multiples of 4095 chips modulo h(x). Once a family of seed values is determined, these values are stored in memory and assigned to logical channels as necessary. Once assigned, the initial seed value is simply loaded into LFSR to produce the required spreading code sequence associated with the seed value.

### Epoch and Sub-epoch Structures

The long complex spreading codes used for the system of the current invention have a number of chips after which the code repeats. The repetition period of the spreading sequence is called an epoch. To map the logical channels to CDMA spreading codes, the present invention uses an Epoch and Sub-epoch structure. The code period for the CDMA spreading code to modulate logical channels is 29877120 chips/code period which is the same number of chips for all bandwidths. The code period is the epoch of the present invention, and the Table 2 defines the epoch duration for the supported chip rates. In addition, two sub-epochs are defined over the spreading code epoch and are 233415 chips and 128 chips long.

The 233415 chip sub-epoch is referred to as a long sub-epoch, and is used for synchronizing events on the RF communication interface such as encryption key switching and changing from global to assigned codes. The 128 chip short epoch is defined for use as an additional timing reference. The highest symbol rate used with a single CDMA code is 64 ksym/sec. There is always an integer number of chips in a symbol duration for the supported symbol rates 64, 32, 16, and 8 ksym/s.

Table 2

| Bandwidths, Chip Rates, and Epochs | | | | | |
|---|---|---|---|---|---|
| Bandwidth (MHz) | Chip Rate, Complex (Mchip/sec) | number of chips in a 64 kbit/sec symbol | 128 chip sub-epoch duration* (μs) | 233415 chip sub-epoch duration* (ms) | Epoch duration (sec) |
| 7 | 5.824 | 91 | 21.978 | 40.078 | 5.130 |
| 10 | 8.320 | 130 | 15.385 | 28.055 | 3.591 |
| 10.5 | 8.512 | 133 | 15.038 | 27.422 | 3.510 |
| 14 | 11.648 | 182 | 10.989 | 20.039 | 2.565 |
| 15 | 12.480 | 195 | 10.256 | 18.703 | 2.394 |

\* numbers in these columns are rounded to 5 digits.

Cyclic sequences of the prior art are generated using linear feedback shift register (LFSR) circuits. This method, however, does not generate sequences of even length. One embodiment of the spreading code sequence generator using the code seeds generated previously is shown in Figure 2a, Figure 2b, and Figure 2c. The exemplary system uses a 36 stage LFSR 201 to generate a sequence of period $N'=233415=3^3 x5x7x13x19$, which is $C_o$ in Figure 2a. In the Figures 2a. 2b, and 2c the symbol $\oplus$ represents a binary addition (EXCLUSIVE-OR). A sequence generator designed as above generates the in-phase and quadrature parts of a set of complex sequences. The tap connections and initial state of the 36 stage LFSR determine the sequence generated by this circuit. The tap coefficients of the 36 stage LFSR are determined such that the resulting sequences have the period 233415. Note that the tap connections shown in Figure 2a correspond to the polynomial given in equation (2). Each resulting sequence is then overlaid by binary addition with the 128 length sequence C∗ to obtain the epoch period 29877120.

Figure 2b shows a Feed Forward (FF) circuit 202 which is used in the code generator. The signal X[n-1] is output of the chip delay 211, and the input of the chip delay 211 is X[n]. The code chip C[n] is formed by the logical adder 212 from the input X[n] and X[n-1]. Figure 2c shows the complete spreading code generator. From the LFSR 201, output signals go through a chain of up to 63 single stage FFs 203 cascaded as shown. The output of each FF is overlaid with the short, even code sequence C∗ which has a period of $128=2^7$. the short code sequence C∗ is stored in code memory 222 and exhibits spectral characteristics of a pseudorandom sequence to obtain the epoch N=29877120 when combined with the sequences provided by the FFs 203. This sequence of 128 is determined by using an m-sequence (PN sequence) of length $127=2^7-1$ and adding a bit-value, such as logic 0, to the sequence to increase the length to 128 chips. The even code sequence C∗ is input to the even code shift register 221, which is a cyclic register, that continually outputs the sequence. The short sequence is then combined with the long sequence using an EXCLUSIVE-OR operation 213, 214, 220.

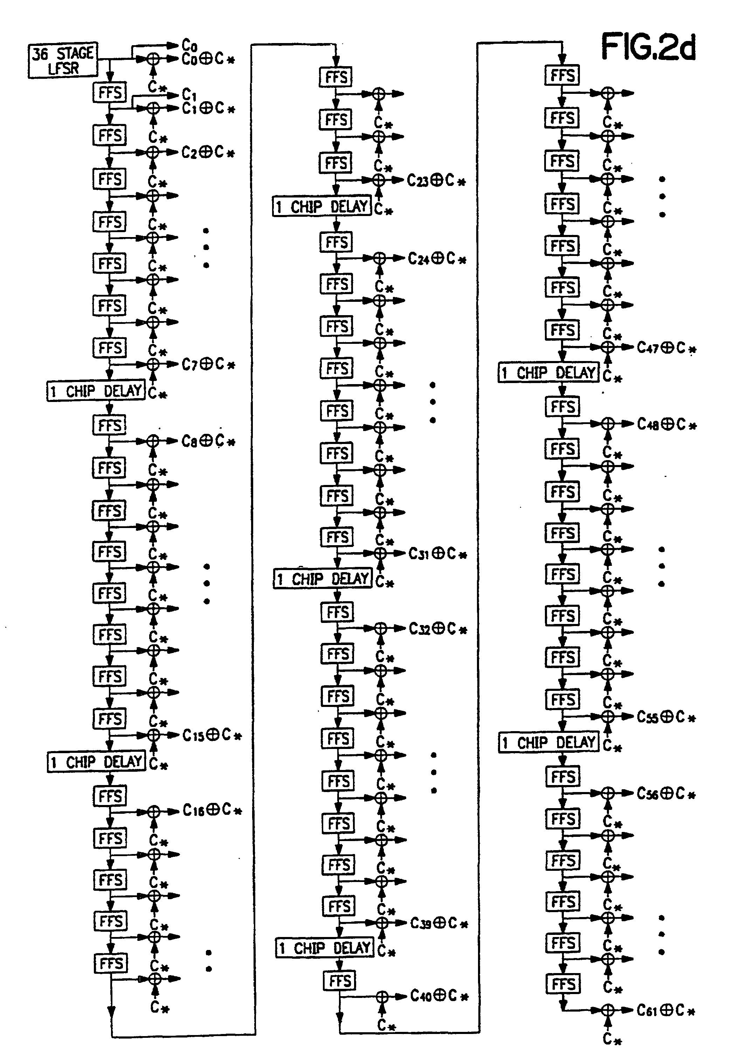

As shown in Figure 2c, up to 63 spreading code sequences $C_o$ through $C_{63}$ are generated by tapping the output signals of FFs 203 and logically adding the short sequence C∗ in a binary adders 213, 214, and 220, for example. One skilled in the art would realize that the implementation of the FF 203 create a cumulative delay effect for the code sequences produced at each FF stage in the chain. This delay is due to the nonzero electrical delay in the electronic components of the implementation. The timing problems associated with the delay can be mitigated by inserting additional delay elements into the FF chain. An exemplary FF chain with additional delay elements is shown in Figure 2d.

The code-generators in the exemplary system are configured to generate either global codes, or assigned codes. Global codes are CDMA codes that can be received or transmitted by all users of the system. Assigned codes are CDMA codes that are allocated for a particular connection. When a family of sequences is generated from the same generator as described, only the seed of the 36 stage LFSR is specified. Sequences for all the global codes, are generated using the same LFSR circuit. Therefore, once an SU has synchronized to the Global pilot signal from an RCS and knows the seed for the LFSR circuit for the Global Channel codes, it can generate not only the pilot sequence but also all other global codes used by the RCS.

The signal that is upconverted to RF is generated as follows. The spreading sequences produced by the above shift register circuits are converted to an antipodal sequence (0 maps into +1, 1 maps into -1). The Logical channels are initially converted to QPSK signals, which are mapped as constellation points as is well known in the art. The In-phase and Quadrature channels of each QPSK signal form the real and imaginary parts of the complex data value. Similarly, two spreading codes are used to form complex spreading chip values. The complex data and complex spreading code are multiplied to produce a spread-spectrum data signal. Similarly, for despreading, the received complex data is correlated with the conjugate of the complex spreading code to recover the data signal.

**Short Codes**

Short codes are used for the initial ramp-up process when an SU accesses an RCS. The period of the short codes is equal to the symbol duration and the start of each period is aligned with a symbol boundary. Both the SUs and the RCS derive the real and imaginary parts of the short codes from the last eight feed-forward sections of the sequence generator to produce the global codes for that cell.

The signals represented by these short codes are known as Short Access Channel pilots (SAXPTs)

**Mapping of Logical Channels to Spreading Codes**

The exact relationship between the spreading code sequences and the CDMA logical channels and pilot signals is documented in Table 3a and Table 3b. Those signal names ending in '-CH' correspond to logical channels. Those signal names ending in '-PT' correspond to pilot signals, which are described in detail below.

Table 3a:

| Spreading code sequences and global CDMA codes | | | |
|---|---|---|---|
| Sequence | Quadrature | Logical Channel or Pilot Signal | Direction |
| $C_0$ | I | FBCH | Forward (F) |
| $C_1$ | Q | FBCH | F |
| $C_2 \oplus C^*$ | I | GLPT | F |
| $C_3 \oplus C^*$ | Q | GLPT | F |
| $C_4 \oplus C^*$ | I | SBCH | F |
| $C_5 \oplus C^*$ | Q | SBCH | F |
| $C_6 \oplus C^*$ | I | CTCH (0) | F |
| $C_7 \oplus C^*$ | Q | CTCH (0) | F |
| $C_8 \oplus C^*$ | I | APCH (1) | F |
| $C_9 \oplus C^*$ | Q | APCH (1) | F |
| $C_{10} \oplus C^*$ | I | CTCH (1) | F |
| $C_{11} \oplus C^*$ | Q | CTCH (1) | F |
| $C_{12} \oplus C^*$ | I | APCH (1) | F |
| $C_{13} \oplus C^*$ | Q | APCH (1) | F |
| $C_{14} \oplus C^*$ | I | CTCH (2) | F |
| $C_{15} \oplus C^*$ | Q | CTCH (2) | F |
| $C_{16} \oplus C^*$ | I | APCH (2) | F |
| $C_{17} \oplus C^*$ | Q | APCH (2) | F |
| $C_{18} \oplus C^*$ | I | CTCH (3) | F |
| $C_{19} \oplus C^*$ | Q | CTCH (3) | F |
| $C_{20} \oplus C^*$ | I | APCH (3) | F |
| $C_{21} \oplus C^*$ | Q | APCH (3) | F |
| $C_{22} \oplus C^*$ | I | reserved | - |
| $C_{23} \oplus C^*$ | Q | reserved | - |
| .... | .... | .... | .... |
| .... | .... | .... | .... |
| $C_{40} \oplus C^*$ | I | reserved | - |

Table 3a:   (continued)

| Spreading code sequences and global CDMA codes | | | |
|---|---|---|---|
| Sequence | Quadrature | Logical Channel or Pilot Signal | Direction |
| $C_{41} \oplus C*$ | Q | reserved | - |
| $C_{42} \oplus C*$ | I | AXCH(3) | Reverse (R) |
| $C_{43} \oplus C*$ | Q | AXCH(3) | R |
| $C_{44} \oplus C*$ | I | LAXPT(3) SAXPT(3) seed | R |
| $C_{45} \oplus C*$ | Q | LAXPT(3) SAXPT(3) seed | R |
| $C_{46} \oplus C*$ | I | AXCH(2) | R |
| $C_{47} \oplus C*$ | Q | AXCH(2) | R |
| $C_{48} \oplus C*$ | I | LAXPT(2) SAXPT(2) seed | R |
| $C_{49} \oplus C*$ | Q | LAXPT(2) SAXPT(2) seed | R |
| $C_{50} \oplus C*$ | I | AXCH(1) | R |
| $C_{51} \oplus C*$ | Q | AXCH(1) | R |
| $C_{52} \oplus C*$ | I | LAXPT(1) SAXPT(1) seed | R |
| $C_{53} \oplus C*$ | Q | LAXPT(1) SAXPT(1) seed | R |
| $C_{54} \oplus C*$ | I | AXCH(0) | R |
| $C_{55} \oplus C*$ | Q | AXCH(0) | R |
| $C_{56} \oplus C*$ | I | LAXPT(0) SAXPT(0) seed | R |
| $C_{57} \oplus C*$ | Q | LAXPT(0) SAXPT(0) seed | R |
| $C_{58} \oplus C*$ | I | IDLE | - |
| $C_{59} \oplus C*$ | Q | IDLE | - |
| $C_{60} \oplus C*$ | I | AUX | R |
| $C_{61} \oplus C*$ | Q | AUX | R |
| $C_{62} \oplus C*$ | I | reserved | - |
| $C_{63} \oplus C*$ | Q | reserved | - |

Table 3b:

| Spreading code sequences and assigned CDMA codes. | | | |
|---|---|---|---|
| Sequence | Quadrature | Logical Channel or Pilot Signal | Direction |
| $C_0 \oplus C*$ | I | ASPT | Reverse (R) |
| $C_1 \oplus C*$ | Q | ASPT | R |
| $C_2 \oplus C*$ | I | APCH | R |
| $C_3 \oplus C*$ | Q | APCH | R |

Table 3b: (continued)

| Spreading code sequences and assigned CDMA codes. | | | |
|---|---|---|---|
| Sequence | Quadrature | Logical Channel or Pilot Signal | Direction |
| $C_4 \oplus C*$ | I | OWCH | R |
| $C_5 \oplus C*$ | Q | OWCH | R |
| $C_6 \oplus C*$ | I | TRCH(0) | R |
| $C_7 \oplus C*$ | Q | TRCH(0) | R |
| $C_8 \oplus C*$ | I | TRCH(1) | R |
| $C_9 \oplus C$ | Q | TRCH(1) | R |
| $C_{10} \oplus C*$ | I | TRCH(2) | R |
| $C_{11} \oplus C*$ | Q | TRCH(2) | R |
| $C_{12} \oplus C*$ | I | TRCH(3) | R |
| $C_{13} \oplus C*$ | Q | TRCH(3) | R |
| $C_{14} \oplus C*$ | I | reserved | - |
| $C_{15} \oplus C*$ | Q | reserved | - |
| .... | .... | .... | .... |
| .... | .... | .... | .... |
| $C_{44} \oplus C*$ | I | reserved | - |
| $C_{45} \oplus C*$ | Q | reserved | - |
| $C_{46} \oplus C*$ | I | TRCH(3) | Forward (F) |
| $C_{47} \oplus C*$ | Q | TRCH(3) | F |
| $C_{48} \oplus C*$ | I | TRCH(2) | F |
| $C_{49} \oplus C*$ | Q | TRCH(2) | F |
| $C_{50} \oplus C*$ | I | TRCH(1) | F |
| $C_{51} \oplus C*$ | Q | TRCH(1) | F |
| $C_{52} \oplus C*$ | I | TRCH(0) | F |
| $C_{53} \oplus C*$ | Q | TRCH(0) | F |
| $C_{54} \oplus C*$ | I | OWCH | F |
| $C_{55} \oplus C*$ | Q | OWCH | F |
| $C_{56} \oplus C*$ | I | APCH | F |
| $C_{57} \oplus C*$ | Q | APCH | F |
| $C_{58} \oplus C*$ | I | IDLE | - |
| $C_{59} \oplus C*$ | Q | IDLE | - |
| $C_{60} \oplus C*$ | I | reserved | - |
| $C_{61} \oplus C*$ | Q | reserved | - |
| $C_{62} \oplus C*$ | I | reserved | - |
| $C_{63} \oplus C*$ | Q | reserved | - |

**Pilot Signals**

As described above, the pilot signals are used for synchronization, carrier phase recovery, and for estimating the impulse response of the radio channel. The RCS 104 transmits a forward link pilot carrier reference as a complex pilot code sequence to provide a time and phase reference for all SUs 111, 112, 115, 117 and 118 in its service area. The power level of the Global Pilot (GLPT) signal is set to provide adequate coverage over the whole RCS service area, which area depends on the cell size. With only one pilot signal in the forward link, the reduction in system capacity due to the pilot energy is negligible.

Each of the SUs 111, 112, 115, 117 and 118 transmits a pilot carrier reference as a quadrature modulated (complex-valued) pilot spreading code sequence to provide time and phase reference to the RCS for the reverse link. The pilot signal transmitted by the SU of one embodiment of the invention is 6 dB lower than the power of the 32 kbit/s POTS (plain old telephone service) traffic channel. The reverse pilot channel is subject to APC. The reverse link pilot associated with a particular connection is called the Assigned Pilot (ASPT). In addition, there are pilot signals associated with access channels, and these are called the Long Access Channel Pilots (LAXPTs). Short access channel pilots (SAXPTs) are also associated with the access channels and used for spreading code acquisition and initial power ramp-up.

All pilot signals are formed from complex codes, as defined below:

$$\text{GLPT (forward)} = \{C_2 \oplus C* ) + j.(C_3 \oplus C*)\} \, . \, \{(\pm 1) + j.(0)\}$$

$$\{ \text{ Complex Code } \} \, . \, \{ \text{ Carrier } \}$$

The complex pilot signals are de-spread by multiplication with conjugate spreading codes: $\{(C_2 \oplus C*) - j.(C_3 \oplus C*)\}$. By contrast, traffic channels are of the form:

$$\text{TRCH}_n(\text{forward/reverse}) = ((C_k \oplus C*) + j.(C_1 \oplus C*)\} \, . \, \{ (\pm 1) + j(\pm 1) \}$$

$$\{ \text{ Complex Codes } \} \, . \, \{ \text{ Data Symbol } \}$$

which thus form a constellation set at $\frac{\pi}{4}$ radians with respect to the pilot signal constellations.

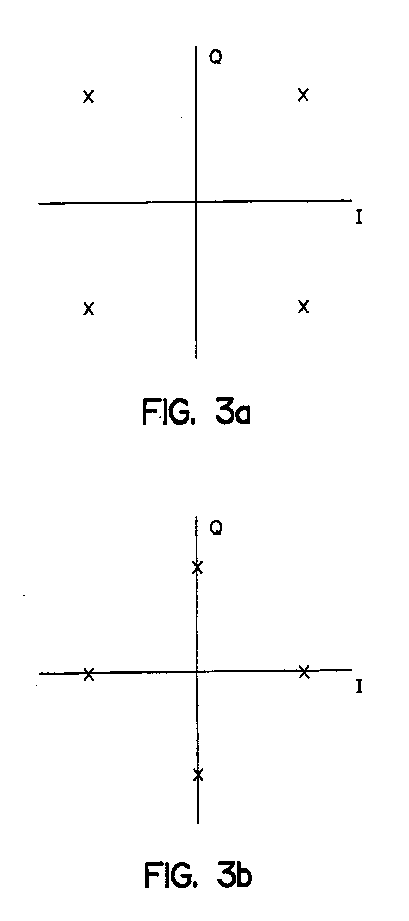

The GLPT constellation is shown in Figure 3a, and the TRCHn traffic channel constellation is shown in Figure 3b.

## Logical Channel Assignment of the FBCH, SBCH, and Traffic Channels

The fast broadcast channel (FBCH) is a global forward link channel used to broadcast dynamic information about the availability of services and access channels (AXCHs). The messages are sent continuously, and each message lasts approximately 1 ms. The FBCH message is 16 bits long. repeated continuously, and epoch aligned. The FBCH is formatted as defined in Table 4.

Table 4:

| FBCH format | |
|---|---|
| Bit | Definition |
| 0 | Traffic Light 0 |
| 1 | Traffic Light 1 |
| 2 | Traffic Light 2 |
| 3 | Traffic Light 3 |
| 4-7 | service indicator bits |
| 8 | Traffic Light 0 |
| 9 | Traffic Light 1 |
| 10 | Traffic Light 2 |
| 11 | Traffic Light 3 |
| 12-15 | service indicator bits |

For the FBCH, bit 0 is transmitted first. A traffic light corresponds to an Access Channel (AXCH) and indicates whether the particular access channel is currently in use (red) or not in use (green). A logic '1' indicates that the traffic light is green, and a logic '0' indicates the traffic light is red. The values of the traffic light bits may change from octet to octet, and each 16 bit message contains distinct service indicator bits which describe which types of service are available for the AXCHs.

One embodiment of the present invention uses service indicator bits as follows to indicate the availability of services or AXCHs. The service indicator bits {4,5,6,7,12,13,14,15} are interpreted as an unsigned binary number, with bit 4 as the MSB and bit 15 as the LSB. Each service type increment has an associated nominal measure of the capacity required, and the FBCH continuously broadcasts the available capacity. This is scaled to have a maximum value equivalent to the largest single service increment possible. When an SU requires a new service or an increase in the number of bearers), it compares the capacity required to that indicated by the FBCH, and then considers itself blocked if the capacity is not available. The FBCH and the traffic channels are aligned to the epoch.

Slow Broadcast Information frames contain system or other general information that is available to all SUs, and Paging Information frames contain information about call requests for particular SUs. Slow Broadcast Information frames and Paging Information frames are multiplexed together on a single logical channel which forms the Slow Broadcast Channel (SBCH). As previously defined, the code epoch is a sequence of 29 877 20 chips having an epoch duration which is a function of the chip rate defined in Table 5 below. In order to facilitate power saving, the channel is divided into N "Sleep" Cycles, and each Cycle is subdivided into M Slots, which are 19 ms long, except for 10.5 Mhz bandwidth which has slots of 18 ms.

Table 5:

| SBCH Channel Format Outline | | | | | | |
|---|---|---|---|---|---|---|
| Bandwidth (MHz) | Spreading Code Rate (MHz) | Epoch-Length (ms) | Cycles/ Epoch N | Cycle Length (ms) | Slots/ Cycle M | Slot Length (ms) |
| 7.0 | 5.824 | 5130 | 5 | 1026 | 54 | 19 |
| 10.0 | 8.320 | 3591 | 3 | 1197 | 63 | 19 |
| 10.5 | 8.512 | 3510 | 3 | 1170 | 65 | 18 |
| 14.0 | 11.648 | 2565 | 3 | 855 | 45 | 19 |
| 15.0 | 12.480 | 2394 | 2 | 1197 | 63 | 19 |

Sleep Cycle Slot #1 is always used for slow broadcast information. Slots #2 to #M-1 are used for paging groups unless extended slow broadcast information is inserted. The pattern of cycles and slots in one embodiment of the present invention run continuously at 16 kbit/s.

Within each Sleep Cycle the SU may power-up the receiver and re-acquire pilot code to achieve carrier lock to a sufficient precision for satisfactory demodulation and Viterbi decoding. This settling time may be up to 3 Slots in duration. For example, an SU assigned to Slot #7 may power up the Receiver at the start of Slot #4. Having monitored its Slot the SU either recognizes its Paging Address and initiates an access request, or fails to recognize its Paging Address in which case it reverts to the Sleep mode.

**Spreading code Tracking and AMF Detection in Multipath Channels**

**Spreading code Tracking**

Three CDMA spreading code tracking methods in multipath fading environments are described which track the code phase of a received multipath spread spectrum signal. The first method uses the prior art tracking circuit which simply tracks the spreading code phase of the detector having the highest output signal value, the second method uses a tracking circuit that tracks the median value of the code phase of the group of multipath signals, and the third method of the present invention, is the centroid tracking circuit which tracks the code-phase of an optimized, least mean squared weighted average of the multipath signal components. The following describes the algorithms by which the spreading code phase of the received CDMA signal is tracked.

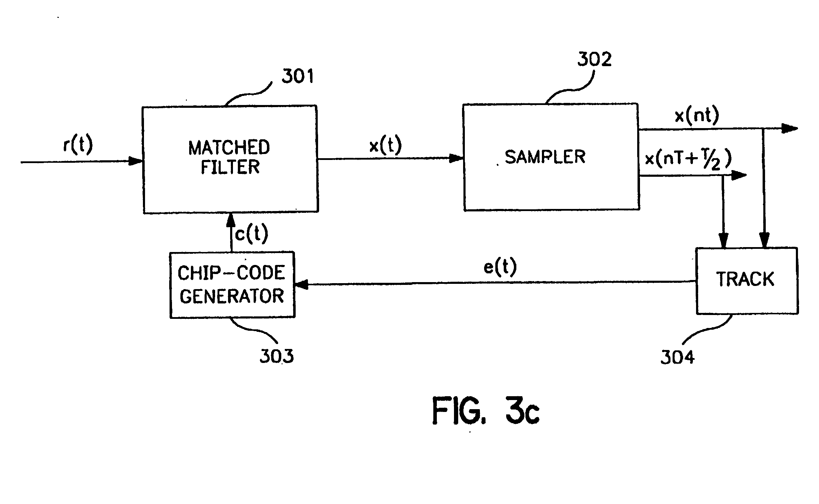

A tracking circuit has operating characteristics that reveal the relationship between the time error and the control voltage that drives a Voltage Controlled Oscillator (VCO) of a spreading code phase tracking circuit. When there is a positive timing error, the exemplary tracking circuit generates a negative control voltage to offset the timing error. When there is a negative timing error, the exemplary tracking circuit generates a positive control voltage to offset the timing error. When the tracking circuit generates a zero value, this value corresponds to the perfect time alignment called the 'lock-point'. Figure 3c shows the basic tracking circuit. Received signal r(t) is applied to matched filter 301, which correlates r(t) with a local code-sequence c(t) generated by Code Generator 303. The output signal of the matched filter x(t) is sampled at the sampler 302 to produce samples x[nT] and x[nT + T/2]. The samples x[nT] and x[nT + T/2] are used by a tracking circuit 304 to determine if the phase of the spreading code c(t) of the code generator 303 is correct. The tracking circuit 304 produces an error signal e(t) as an input to the code generator 303. The code generator 303 uses this signal e(t) as an input signal to adjust the code-phase it generates.

In a CDMA system, the signal transmitted by the reference user is written in the low-pass representation as

$$s(t) = \sum_{k=-\infty}^{\infty} c_k P_{Tc}(t - kT_c) \qquad (4)$$

where $c_k$ represents the spreading code coefficients, $P_{Te}(t)$ represents the spreading code chip waveform, and $T_e$ is the chip duration. Assuming that the reference user is not transmitting data, only the spreading code modulates the carrier. Referring to Figure 3, the received signal is

$$r(t) = \sum_{i=1}^{M} a_i s(t - \tau_i). \qquad (5)$$

Here, $a_i$ is due to fading effect of the multipath channel on the i-th path and $\tau_i$ is the random time delay associated with the same path. The receiver passes the received signal through a matched filter, which is implemented as a correlation receiver and is described below. This operation is done in two steps: first the signal is passed through a chip matched filter and sampled to recover the spreading code chip values, then this chip sequence is correlated with the locally generated code sequence.

Figure 3c shows the chip matched filter 301, matched to the chip waveform $P_{Tc}(t)$, and the sampler 302. The signal $x(t)$ at the output terminal of the chip matched filter is

$$x(t) = \sum_{i=k}^{M} \sum_{k=-\infty}^{\infty} a_i c_k g(t - \tau_i - kT_c) \qquad (6)$$

where

$$g(t) = P_{Tc}(t)*h_R(t) \qquad (7)$$

Here, $h_R(t)$ is the impulse response of the chip matched filter and '*' denotes convolution. The order of the summations, can be rewritten as:

$$x(t) = \sum_{k=-\infty}^{\infty} c_k f(t - kT_c) \qquad (8)$$

where

$$f(t) = \sum_{i=1}^{M} a_i g(t - \tau_i) \qquad (9)$$

In the multipath channel described above, the sampler samples the output signal of the matched filter to produce x(nT) at the maximum power level points of g(t). In practice, however, the waveform *g(t)* is often severely distorted because of the effect of the multipath signal reception, and a perfect time alignment of the signals is not available.

When the multipath in the channel is negligible and a perfect estimate of the timing is available, i.e., $a_1 = 1$, $\tau_1 = 0$, and $a_i = 0$, i = 2,...,M, the received signal is r(t) = s(t). Then, with this ideal channel model, the output of the chip matched filter becomes

$$x(t) = \sum_{k=-\infty}^{\infty} c_k g(t - kT_c) \qquad (10)$$

When there is multipath fading, however, the received spreading code chip value waveform is distorted, and has a number of local maxima that can change from one sampling interval to another depending on the channel characteristics.

For multipath fading channels with quickly changing channel characteristics, it is not practical to try to locate the maximum of the waveform *f(t)* in every chip period interval. Instead, a time reference can be obtained from the characteristics of *f(t)* that may not change as quickly. Three tracking methods are described based on different characteristics of *f(t)*.

| | | | | | | | | | | | |
|---|---|---|---|---|---|---|---|---|---|---|---|
| 0 | 67 | 134 | 201 | 268 | 335 | 402 | 469 | 536 | 603 | 670 | 737 |
| 1 | 68 | 135 | 202 | 269 | 336 | 403 | 470 | 537 | 604 | 671 | 738 |
| 2 | 69 | 136 | 203 | 270 | 337 | 404 | 471 | 538 | 605 | 672 | 739 |
| 3 | 70 | 137 | 204 | 271 | 338 | 405 | 472 | 539 | 606 | 673 | 740 |
| 4 | 71 | 138 | 205 | 272 | 339 | 406 | 473 | 540 | 607 | 674 | 741 |
| 5 | 72 | 139 | 206 | 273 | 340 | 407 | 474 | 541 | 608 | 675 | 742 |
| 6 | 73 | 140 | 207 | 274 | 341 | 408 | 475 | 542 | 609 | 676 | 743 |
| 7 | 74 | 141 | 208 | 275 | 342 | 409 | 476 | 543 | 610 | 677 | 744 |
| 8 | 75 | 142 | 209 | 276 | 343 | 410 | 477 | 544 | 611 | 678 | 745 |
| 9 | 76 | 143 | 210 | 277 | 344 | 411 | 478 | 545 | 612 | 679 | 746 |
| 10 | 77 | 144 | 211 | 278 | 345 | 412 | 479 | 546 | 613 | 680 | 747 |
| 11 | 78 | 145 | 212 | 279 | 346 | 413 | 480 | 547 | 614 | 681 | 748 |
| 12 | 79 | 146 | 213 | 280 | 347 | 414 | 481 | 548 | 615 | 682 | 749 |
| 13 | 80 | 147 | 214 | 281 | 348 | 415 | 482 | 549 | 616 | 683 | 750 |
| 14 | 81 | 148 | 215 | 282 | 349 | 416 | 483 | 550 | 617 | 684 | 751 |
| 15 | 82 | 149 | 216 | 283 | 350 | 417 | 484 | 551 | 618 | 685 | 752 |
| 16 | 83 | 150 | 217 | 284 | 351 | 418 | 485 | 552 | 619 | 686 | 753 |
| 17 | 84 | 151 | 218 | 285 | 352 | 419 | 486 | 553 | 620 | 687 | 754 |
| 18 | 85 | 152 | 219 | 286 | 353 | 420 | 487 | 554 | 621 | 688 | 755 |
| 19 | 86 | 153 | 220 | 287 | 354 | 421 | 488 | 555 | 622 | 689 | 756 |
| 20 | 87 | 154 | 221 | 288 | 355 | 422 | 489 | 556 | 623 | 690 | 757 |
| 21 | 88 | 155 | 222 | 289 | 356 | 423 | 490 | 557 | 624 | 691 | 758 |
| 22 | 89 | 156 | 223 | 290 | 357 | 424 | 491 | 558 | 625 | 692 | 759 |
| 23 | 90 | 157 | 224 | 291 | 358 | 425 | 492 | 559 | 626 | 693 | 760 |
| 24 | 91 | 158 | 225 | 292 | 359 | 426 | 493 | 560 | 627 | 694 | 761 |
| 25 | 92 | 159 | 226 | 293 | 360 | 427 | 494 | 561 | 628 | 695 | 762 |
| 26 | 93 | 160 | 227 | 294 | 361 | 428 | 495 | 562 | 629 | 696 | 763 |
| 27 | 94 | 161 | 228 | 295 | 362 | 429 | 496 | 563 | 630 | 697 | 764 |
| 28 | 95 | 162 | 229 | 296 | 363 | 430 | 497 | 564 | 631 | 698 | 765 |
| 29 | 96 | 163 | 230 | 297 | 364 | 431 | 498 | 565 | 632 | 699 | 766 |
| 30 | 97 | 164 | 231 | 298 | 365 | 432 | 499 | 566 | 633 | 700 | 767 |
| 31 | 98 | 165 | 232 | 299 | 366 | 433 | 500 | 567 | 634 | 701 | 768 |
| 32 | 99 | 166 | 233 | 300 | 367 | 434 | 501 | 568 | 635 | 702 | 769 |

(continued)

| | | | | | | | | | | | |
|---|---|---|---|---|---|---|---|---|---|---|---|
| 33 | 100 | 167 | 234 | 301 | 368 | 435 | 502 | 569 | 636 | 703 | 770 |
| 34 | 101 | 168 | 235 | 302 | 369 | 436 | 503 | 570 | 637 | 704 | 771 |
| 35 | 102 | 169 | 236 | 303 | 370 | 437 | 504 | 571 | 638 | 705 | 772 |
| 36 | 103 | 170 | 237 | 304 | 371 | 438 | 505 | 572 | 639 | 706 | 773 |
| 37 | 104 | 171 | 238 | 305 | 372 | 439 | 506 | 573 | 640 | 707 | 774 |
| 38 | 105 | 172 | 239 | 306 | 373 | 440 | 507 | 574 | 641 | 708 | 775 |
| 39 | 106 | 173 | 240 | 307 | 374 | 441 | 508 | 575 | 642 | 709 | 776 |
| 40 | 107 | 174 | 241 | 308 | 375 | 442 | 509 | 576 | 643 | 710 | 777 |
| 41 | 108 | 175 | 242 | 309 | 376 | 443 | 510 | 577 | 644 | 711 | 778 |
| 42 | 109 | 176 | 243 | 310 | 377 | 444 | 511 | 578 | 645 | 712 | 779 |
| 43 | 110 | 177 | 244 | 311 | 378 | 445 | 512 | 579 | 646 | 713 | 780 |
| 44 | 111 | 178 | 245 | 312 | 379 | 446 | 513 | 580 | 647 | 714 | 781 |
| 45 | 112 | 179 | 246 | 313 | 380 | 447 | 514 | 581 | 648 | 715 | 782 |
| 46 | 113 | 180 | 247 | 314 | 381 | 448 | 515 | 582 | 649 | 716 | 783 |
| 47 | 114 | 181 | 248 | 315 | 382 | 449 | 516 | 583 | 650 | 717 | 784 |
| 48 | 115 | 182 | 249 | 316 | 383 | 450 | 517 | 584 | 651 | 718 | 785 |
| 49 | 116 | 183 | 250 | 317 | 384 | 451 | 518 | 585 | 652 | 719 | 786 |
| 50 | 117 | 184 | 251 | 318 | 385 | 452 | 519 | 586 | 653 | 720 | 787 |
| 51 | 118 | 185 | 252 | 319 | 386 | 453 | 520 | 587 | 654 | 721 | 788 |
| 52 | 119 | 186 | 253 | 320 | 387 | 454 | 521 | 588 | 655 | 722 | 789 |
| 53 | 120 | 187 | 254 | 321 | 388 | 455 | 522 | 589 | 656 | 723 | 790 |
| 54 | 121 | 188 | 255 | 322 | 389 | 456 | 523 | 590 | 657 | 724 | 791 |
| 55 | 122 | 189 | 256 | 323 | 390 | 457 | 524 | 591 | 658 | 725 | 792 |
| 56 | 123 | 190 | 257 | 324 | 391 | 458 | 525 | 592 | 659 | 726 | 793 |
| 57 | 124 | 191 | 258 | 325 | 392 | 459 | 526 | 593 | 660 | 727 | 794 |
| 58 | 125 | 192 | 259 | 326 | 393 | 460 | 527 | 594 | 661 | 728 | 795 |
| 59 | 126 | 193 | 260 | 327 | 394 | 461 | 528 | 595 | 662 | 729 | 796 |
| 60 | 127 | 194 | 261 | 328 | 395 | 462 | 529 | 596 | 663 | 730 | 797 |
| 61 | 128 | 195 | 262 | 329 | 396 | 463 | 530 | 597 | 664 | 731 | 798 |
| 62 | 129 | 196 | 263 | 330 | 397 | 464 | 531 | 598 | 665 | 732 | 799 |
| 63 | 130 | 197 | 264 | 331 | 398 | 465 | 532 | 599 | 666 | 733 | 800 |
| 64 | 131 | 198 | 265 | 332 | 399 | 466 | 533 | 600 | 667 | 734 | 801 |
| 65 | 132 | 199 | 266 | 333 | 400 | 467 | 534 | 601 | 668 | 735 | 802 |
| 66 | 133 | 200 | 267 | 334 | 401 | 468 | 535 | 602 | 669 | 736 | 803 |
| 804 | 871 | 938 | 1005 | 1072 | 2241 | 2308 | 2375 | 2442 | 2509 | 2576 | 2643 |
| 805 | 872 | 939 | 1006 | 1073 | 2242 | 2309 | 2376 | 2443 | 2510 | 2577 | 2644 |
| 806 | 873 | 940 | 1007 | 1074 | 2243 | 2310 | 2377 | 2444 | 2511 | 2578 | 2645 |
| 807 | 874 | 941 | 1008 | 1075 | 2244 | 2311 | 2378 | 2445 | 2512 | 2579 | 2646 |
| 808 | 875 | 942 | 1009 | 1076 | 2245 | 2312 | 2379 | 2446 | 2513 | 2580 | 2647 |
| 809 | 876 | 943 | 1010 | 1077 | 2246 | 2313 | 2380 | 2447 | 2514 | 2581 | 2648 |
| 810 | 877 | 944 | 1011 | 1078 | 2247 | 2314 | 2381 | 2448 | 2515 | 2582 | 2649 |
| 811 | 878 | 945 | 1012 | 1079 | 2248 | 2315 | 2382 | 2449 | 2516 | 2583 | 2650 |
| 812 | 879 | 946 | 1013 | 1080 | 2249 | 2316 | 2383 | 2450 | 2517 | 2584 | 2651 |
| 813 | 880 | 947 | 1014 | 1081 | 2250 | 2317 | 2384 | 2451 | 2518 | 2585 | 2652 |
| 814 | 881 | 948 | 1015 | 1082 | 2251 | 2318 | 2385 | 2452 | 2519 | 2586 | 2653 |
| 815 | 882 | 949 | 1016 | 1083 | 2252 | 2319 | 2386 | 2453 | 2520 | 2587 | 2654 |
| 816 | 883 | 950 | 1017 | 1084 | 2253 | 2320 | 2387 | 2454 | 2521 | 2588 | 2655 |
| 817 | 884 | 951 | 1018 | 1085 | 2254 | 2321 | 2388 | 2455 | 2522 | 2589 | 2656 |
| 818 | 885 | 952 | 1019 | 1086 | 2255 | 2322 | 2389 | 2456 | 2523 | 2590 | 2657 |
| 819 | 886 | 953 | 1020 | 1087 | 2256 | 2323 | 2390 | 2457 | 2524 | 2591 | 2658 |
| 820 | 887 | 954 | 1021 | 1088 | 2257 | 2324 | 2391 | 2458 | 2525 | 2592 | 2659 |

(continued)

| | | | | | | | | | | | |
|---|---|---|---|---|---|---|---|---|---|---|---|
| 821 | 888 | 955 | 1022 | 1089 | 2258 | 2325 | 2392 | 2459 | 2526 | 2593 | 2660 |
| 822 | 889 | 956 | 1023 | 1090 | 2259 | 2326 | 2393 | 2460 | 2527 | 2594 | 2661 |
| 823 | 890 | 957 | 1024 | 1091 | 2260 | 2327 | 2394 | 2461 | 2528 | 2595 | 2662 |
| 824 | 891 | 958 | 1025 | 1092 | 2261 | 2328 | 2395 | 2462 | 2529 | 2596 | 2663 |
| 825 | 892 | 959 | 1026 | 1093 | 2262 | 2329 | 2396 | 2463 | 2530 | 2597 | 2664 |
| 826 | 893 | 960 | 1027 | 1094 | 2263 | 2330 | 2397 | 2464 | 2531 | 2598 | 2665 |
| 827 | 894 | 961 | 1028 | 1095 | 2264 | 2331 | 2398 | 2465 | 2532 | 2599 | 2666 |
| 828 | 895 | 962 | 1029 | 1096 | 2265 | 2332 | 2399 | 2466 | 2533 | 2600 | 2667 |
| 828 | 996 | 963 | 1030 | 1097 | 2266 | 2333 | 2400 | 2467 | 2534 | 2601 | 2668 |
| 830 | 897 | 964 | 1031 | 1098 | 2267 | 2334 | 2401 | 2468 | 2535 | 2602 | 2669 |
| 831 | 898 | 965 | 1032 | 1099 | 2268 | 2335 | 2402 | 2469 | 2536 | 2603 | 2670 |
| 832 | 899 | 966 | 1033 | 1100 | 2269 | 2336 | 2403 | 2470 | 2537 | 2604 | 2671 |
| 833 | 900 | 967 | 1034 | 1101 | 2270 | 2337 | 2404 | 2471 | 2538 | 2605 | 2672 |
| 834 | 901 | 968 | 1035 | 2204 | 2271 | 2338 | 2405 | 2472 | 2539 | 2606 | 2673 |
| 835 | 902 | 969 | 1036 | 2205 | 2272 | 2339 | 2406 | 2473 | 2540 | 2607 | 2674 |
| 836 | 903 | 970 | 1037 | 2206 | 2273 | 2340 | 2407 | 2474 | 2541 | 2608 | 2675 |
| 837 | 904 | 971 | 1038 | 2207 | 2274 | 2341 | 2408 | 2475 | 2542 | 2609 | 2676 |
| 838 | 905 | 972 | 1039 | 2208 | 2275 | 2342 | 2409 | 2476 | 2543 | 2610 | 2677 |
| 839 | 906 | 973 | 1040 | 2209 | 2276 | 2343 | 2410 | 2477 | 2544 | 2611 | 2678 |
| 840 | 907 | 974 | 1041 | 2210 | 2277 | 2344 | 2411 | 2478 | 2545 | 2612 | 2679 |
| 841 | 908 | 975 | 1042 | 2211 | 2278 | 2345 | 2412 | 2479 | 2546 | 2613 | 2680 |
| 842 | 909 | 976 | 1043 | 2212 | 2279 | 2346 | 2413 | 2480 | 2547 | 2614 | 2681 |
| 843 | 910 | 977 | 1044 | 2213 | 2280 | 2347 | 2414 | 2481 | 2543 | 2615 | 2682 |
| 844 | 911 | 978 | 1045 | 2214 | 2281 | 2348 | 2415 | 2482 | 2549 | 2616 | 2683 |
| 845 | 912 | 979 | 1046 | 2215 | 2282 | 2349 | 2416 | 2483 | 2550 | 2617 | 2684 |
| 846 | 913 | 980 | 1047 | 2216 | 2283 | 2350 | 2417 | 2484 | 2551 | 2618 | 2685 |
| 847 | 914 | 981 | 1048 | 2217 | 2284 | 2351 | 2418 | 2485 | 2552 | 2619 | 2686 |
| 848 | 915 | 982 | 1049 | 2218 | 2285 | 2352 | 2419 | 2486 | 2553 | 2620 | 2687 |
| 849 | 916 | 983 | 1050 | 2219 | 2286 | 2353 | 2420 | 2487 | 25S4 | 2621 | 2688 |
| 850 | 917 | 984 | 1051 | 2220 | 2287 | 2354 | 2421 | 2488 | 2555 | 2622 | 2689 |
| 851 | 918 | 985 | 1052 | 2221 | 2288 | 2355 | 2422 | 2489 | 2556 | 2623 | 2690 |
| 852 | 919 | 986 | 1053 | 2222 | 2289 | 2356 | 2423 | 2490 | 2557 | 2624 | 2691 |
| 853 | 920 | 987 | 1054 | 2223 | 2290 | 2357 | 2424 | 2491 | 2558 | 2625 | 2692 |
| 854 | 921 | 988 | 1055 | 2224 | 2291 | 2358 | 2425 | 2492 | 2559 | 2626 | 2693 |
| 855 | 922 | 989 | 1056 | 2225 | 2292 | 2359 | 2426 | 2493 | 2560 | 2627 | 2694 |
| 856 | 923 | 990 | 1057 | 2226 | 2293 | 2360 | 2427 | 2494 | 2561 | 2628 | 2695 |
| 857 | 924 | 991 | 1058 | 2227 | 2294 | 2361 | 2428 | 2495 | 2562 | 2629 | 2696 |
| 858 | 925 | 992 | 1059 | 2228 | 2295 | 2362 | 2429 | 2496 | 2563 | 2630 | 2697 |
| 859 | 926 | 993 | 1060 | 2229 | 2296 | 2363 | 2430 | 2497 | 2564 | 2631 | 2698 |
| 860 | 927 | 994 | 1061 | 2230 | 2297 | 2364 | 2431 | 2498 | 2565 | 2632 | 2699 |
| 861 | 928 | 995 | 1062 | 2231 | 2298 | 2365 | 2432 | 2499 | 2566 | 2633 | 2700 |
| 862 | 929 | 996 | 1063 | 2232 | 2299 | 2366 | 2433 | 2500 | 2567 | 2634 | 2701 |
| 863 | 930 | 997 | 1064 | 2233 | 2300 | 2367 | 2434 | 2501 | 2568 | 2635 | 2702 |
| 864 | 931 | 998 | 1065 | 2234 | 2301 | 2368 | 2435 | 2502 | 2569 | 2636 | 2703 |
| 865 | 932 | 999 | 1066 | 2235 | 2302 | 2369 | 2436 | 2503 | 2570 | 2637 | 2704 |
| 866 | 933 | 1000 | 1067 | 2236 | 2303 | 2370 | 2437 | 2504 | 2571 | 2638 | 2705 |
| 867 | 934 | 1001 | 1068 | 2237 | 2304 | 2371 | 2438 | 2505 | 2572 | 2639 | 2706 |
| 868 | 935 | 1002 | 1069 | 2238 | 2305 | 2372 | 2439 | 2506 | 2573 | 2640 | 2707 |
| 869 | 936 | 1003 | 1070 | 2239 | 2306 | 2373 | 2440 | 2507 | 2574 | 2641 | 2708 |
| 870 | 937 | 1004 | 1071 | 2240 | 2307 | 2374 | 2441 | 2508 | 2575 | 2642 | 2709 |
| 2710 | 2777 | 2844 | 2911 | 2978 | 3045 | 3112 | 3179 | 3246 | 4415 | 4482 | 4549 |

(continued)

| | | | | | | | | | | | |
|---|---|---|---|---|---|---|---|---|---|---|---|
| 2711 | 2778 | 2845 | 2912 | 2979 | 3046 | 3113 | 3180 | 3247 | 4416 | 4483 | 4550 |
| 2712 | 2779 | 2846 | 2913 | 2980 | 3047 | 3114 | 3181 | 3248 | 4417 | 4484 | 4551 |
| 2713 | 2780 | 2847 | 2914 | 2981 | 3048 | 3115 | 3182 | 3249 | 4418 | 4485 | 4552 |
| 2714 | 2781 | 2848 | 2915 | 2982 | 3049 | 3116 | 3183 | 3250 | 4419 | 4486 | 4553 |
| 2715 | 2782 | 2849 | 2916 | 2983 | 3050 | 3117 | 3184 | 3251 | 4420 | 4487 | 4554 |
| 2716 | 2783 | 2850 | 2917 | 2984 | 3051 | 3118 | 3185 | 3252 | 4421 | 4488 | 4555 |
| 2717 | 2784 | 2851 | 2918 | 2985 | 3052 | 3119 | 3186 | 3253 | 4422 | 4489 | 4556 |
| 2718 | 2785 | 2852 | 2919 | 2986 | 3053 | 3120 | 3187 | 3254 | 4423 | 4490 | 4557 |
| 2719 | 2786 | 2853 | 2920 | 2987 | 3054 | 3121 | 3188 | 3255 | 4424 | 4491 | 4558 |
| 2720 | 2787 | 2854 | 2921 | 2988 | 3055 | 3122 | 3189 | 3256 | 4425 | 4492 | 4559 |
| 2721 | 2788 | 2855 | 2922 | 2989 | 3056 | 3123 | 3190 | 3257 | 4426 | 4493 | 4560 |
| 2722 | 2789 | 2856 | 2923 | 2990 | 3057 | 3124 | 3191 | 3258 | 4427 | 4494 | 4561 |
| 2723 | 2790 | 2857 | 2924 | 2991 | 3058 | 3125 | 3192 | 3259 | 4428 | 4495 | 4562 |
| 2724 | 2791 | 2858 | 2925 | 2992 | 3059 | 3126 | 3193 | 3260 | 4429 | 4496 | 4563 |
| 2725 | 2792 | 2859 | 2926 | 2993 | 3060 | 3127 | 3194 | 3261 | 4430 | 4497 | 4564 |
| 2726 | 2793 | 2860 | 2927 | 2994 | 3061 | 3128 | 3195 | 3263 | 4431 | 4498 | 4565 |
| 2727 | 2794 | 2861 | 2928 | 2295 | 3062 | 3129 | 3196 | 3263 | 4432 | 4499 | 4567 |
| 2728 | 2795 | 2862 | 2929 | 2996 | 3063 | 3130 | 3197 | 3264 | 4433 | 4500 | 4566 |
| 2729 | 2796 | 2863 | 2930 | 2997 | 3064 | 3131 | 3198 | 3265 | 4434 | 4501 | 4568 |
| 2730 | 2797 | 2864 | 2931 | 2998 | 3065 | 3132 | 3199 | 3266 | 4435 | 4502 | 4569 |
| 2731 | 2798 | 2865 | 2932 | 2999 | 3066 | 3133 | 3200 | 3267 | 4436 | 4503 | 4570 |
| 2732 | 2799 | 2866 | 2 2933 | 3000 | 3067 | 3134 | 3201 | 3268 | 4437 | 4504 | 4571 |
| 2733 | 2800 | 2867 | 2934 | 3001 | 3068 | 3135 | 3202 | 3269 | 4438 | 4505 | 4572 |
| 2734 | 2801 | 2868 | 2935 | 3002 | 3069 | 3136 | 3203 | 3270 | 4439 | 4506 | 4573 |
| 2735 | 2803 | 2869 | 2936 | 3003 | 3070 | 3137 | 3204 | 3271 | 4440 | 4507 | 4574 |
| 2736 | 2803 | 2870 | 2937 | 3004 | 3071 | 3138 | 3205 | 3272 | 4441 | 4508 | 4575 |
| 2737 | 2804 | 2871 | 2938 | 3005 | 3072 | 3139 | 3206 | 3273 | 4442 | 4509 | 4576 |
| 2738 | 2805 | 2872 | 2939 | 3006 | 3073 | 3140 | 3207 | 3274 | 4443 | 4510 | 4577 |
| 2739 | 2806 | 2873 | 2940 | 3007 | 3074 | 3141 | 3208 | 3275 | 4444 | 4511 | 4578 |
| 2740 | 2807 | 2874 | 2941 | 3008 | 3075 | 3142 | 3209 | 3276 | 4445 | 4512 | 4579 |
| 2741 | 2808 | 2875 | 2942 | 3009 | 3076 | 3143 | 3210 | 3277 | 4446 | 4513 | 4580 |
| 2742 | 2809 | 2876 | 2943 | 3010 | 3077 | 3144 | 3211 | 3278 | 4447 | 4514 | 4581 |
| 2743 | 2810 | 2877 | 2944 | 3011 | 3078 | 3145 | 3212 | 3279 | 4448 | 4515 | 4582 |
| 2744 | 2811 | 2878 | 2945 | 3012 | 3079 | 3146 | 3213 | 3280 | 4449 | 4516 | 4583 |
| 2745 | 2812 | 2879 | 2946 | 3013 | 3080 | 3147 | 3214 | 3281 | 4450 | 4517 | 4584 |
| 2746 | 2813 | 2880 | 2947 | 3014 | 3081 | 3148 | 3215 | 3282 | 4451 | 4518 | 4585 |
| 2747 | 2814 | 2881 | 2948 | 3015 | 3082 | 3149 | 3216 | 3283 | 4452 | 4519 | 4586 |
| 2748 | 2815 | 2882 | 2949 | 3016 | 3083 | 3150 | 3217 | 3284 | 4453 | 4520 | 4587 |
| 2749 | 2816 | 2883 | 2950 | 3017 | 3084 | 3151 | 3218 | 3285 | 4454 | 4521 | 4588 |
| 2750 | 2817 | 2884 | 2951 | 3018 | 3085 | 3152 | 3219 | 3286 | 4455 | 4522 | 4589 |
| 2751 | 2818 | 2885 | 2952 | 3019 | 3086 | 3153 | 3220 | 3287 | 4456 | 4523 | 4590 |
| 2752 | 2819 | 2886 | 2953 | 3020 | 3087 | 3154 | 3221 | 3288 | 4457 | 4524 | 4591 |
| 2753 | 2820 | 2887 | 2954 | 3021 | 3088 | 3155 | 3222 | 3289 | 4458 | 4525 | 4592 |
| 2754 | 2821 | 2888 | 2955 | 3022 | 3089 | 3156 | 3223 | 3290 | 4459 | 4526 | 4593 |
| 2755 | 2822 | 2889 | 2956 | 3023 | 3090 | 3157 | 3224 | 3291 | 4460 | 4527 | 4594 |
| 2756 | 2823 | 2890 | 2957 | 3024 | 3091 | 3158 | 3225 | 3292 | 4461 | 4528 | 4595 |
| 2757 | 2824 | 2891 | 2958 | 3025 | 3092 | 3159 | 3226 | 3293 | 4462 | 4529 | 4596 |
| 2758 | 2825 | 2892 | 2959 | 3026 | 3093 | 3160 | 3227 | 3294 | 4463 | 4530 | 4597 |
| 2759 | 2826 | 2893 | 2960 | 3027 | 3094 | 3161 | 3228 | 3295 | 4464 | 4531 | 4598 |
| 2760 | 2827 | 2894 | 2961 | 3028 | 3095 | 3162 | 3229 | 3296 | 4465 | 4532 | 4599 |
| 2761 | 2828 | 2895 | 2962 | 3029 | 3096 | 3163 | 3230 | 3297 | 4466 | 4533 | 4600 |

(continued)

| | | | | | | | | | | | |
|---|---|---|---|---|---|---|---|---|---|---|---|
| 2762 | 2829 | 2896 | 2963 | 3030 | 3097 | 3164 | 3231 | 3298 | 4467 | 4534 | 4601 |
| 2763 | 2830 | 2897 | 2964 | 3031 | 3098 | 3165 | 3232 | 3299 | 4468 | 4535 | 4602 |
| 2764 | 2831 | 2898 | 2965 | 3032 | 3099 | 3166 | 3233 | 3300 | 4469 | 4536 | 4603 |
| 2765 | 2832 | 2899 | 2966 | 3033 | 3100 | 3167 | 3234 | 3301 | 4470 | 4537 | 4604 |
| 2766 | 2833 | 2900 | 2967 | 3034 | 3101 | 3168 | 3235 | 3302 | 4471 | 4538 | 4605 |
| 2767 | 2834 | 2901 | 2968 | 3035 | 3102 | 3169 | 3236 | 3303 | 4472 | 4539 | 4606 |
| 2768 | 2835 | 2902 | 2969 | 3036 | 3103 | 3170 | 3237 | 3304 | 4473 | 4540 | 4607 |
| 2769 | 2836 | 2903 | 2970 | 3037 | 3104 | 3171 | 3238 | 3305 | 4474 | 4541 | 4608 |
| 2770 | 2837 | 2904 | 2971 | 3038 | 3105 | 3172 | 3239 | 4408 | 4475 | 4542 | 4609 |
| 2771 | 2838 | 2905 | 2972 | 3039 | 3106 | 3173 | 3240 | 4409 | 4476 | 4543 | 4610 |
| 2772 | 2839 | 2906 | 2973 | 3040 | 3107 | 3174 | 3241 | 4410 | 4477 | 4544 | 4611 |
| 2773 | 2840 | 2907 | 2974 | 3041 | 3108 | 3175 | 3242 | 4411 | 4478 | 4545 | 4612 |
| 2774 | 2841 | 2908 | 2975 | 3042 | 3109 | 3176 | 3243 | 4412 | 4479 | 4546 | 4613 |
| 2775 | 2842 | 2909 | 2976 | 3043 | 3110 | 3177 | 3244 | 4413 | 4480 | 4547 | 4614 |
| 2776 | 2843 | 2910 | 2977 | 3044 | 3111 | 3178 | 3245 | 4414 | 4481 | 4548 | 4615 |
| 4616 | 4683 | 4750 | 4817 | 4884 | 4951 | 5018 | 5085 | 5152 | 5219 | 5286 | 5353 |
| 4617 | 4684 | 4751 | 4818 | 4885 | 4952 | 5019 | 5086 | 5153 | 5220 | 5287 | 5354 |
| 4618 | 4685 | 4752 | 4819 | 4886 | 4953 | 5020 | 5087 | 5154 | 5221 | 5288 | 5355 |
| 4619 | 4686 | 4753 | 4820 | 4887 | 4954 | 5021 | 5088 | 5155 | 5222 | 5289 | 5356 |
| 4620 | 4687 | 4754 | 4821 | 4888 | 4955 | 5022 | 5089 | 5156 | 5223 | 5290 | 5357 |
| 4621 | 4688 | 4755 | 4822 | 4889 | 4956 | 5023 | 5090 | 5157 | 5224 | 5291 | 5358 |
| 4622 | 4689 | 4756 | 4823 | 4890 | 4957 | 5024 | 5091 | 5158 | 5225 | 5292 | 5359 |
| 4623 | 4690 | 4757 | 4824 | 4891 | 4958 | 5025 | 5092 | 5159 | 5226 | 5293 | 5360 |
| 4624 | 4691 | 4758 | 4825 | 4892 | 4959 | 5026 | 5093 | 5160 | 5227 | 5294 | 5361 |
| 4625 | 4692 | 4759 | 4826 | 4893 | 4960 | 5027 | 5094 | 5161 | 5228 | 5295 | 5362 |
| 4626 | 4693 | 4760 | 4827 | 4894 | 4961 | 5028 | 5095 | 5162 | 5229 | 5296 | 5363 |
| 4627 | 4694 | 4761 | 4828 | 4895 | 4962 | 5029 | 5096 | 5163 | 5230 | 5297 | 5364 |
| 4628 | 4695 | 4762 | 4829 | 4896 | 4963 | 5030 | 5097 | 5164 | 5231 | 5298 | 5365 |
| 4629 | 4696 | 4763 | 4830 | 4897 | 4964 | 5031 | 5098 | 5165 | 5232 | 5299 | 5366 |
| 4630 | 4697 | 4764 | 4831 | 4898 | 4965 | 5032 | 5099 | 5166 | 5233 | 5300 | 5367 |
| 4631 | 4698 | 4765 | 4832 | 4899 | 4966 | 5033 | 5100 | 5167 | 5234 | 5301 | 5368 |
| 4632 | 4699 | 4766 | 4833 | 4900 | 4967 | 5034 | 5101 | 5168 | 5235 | 5302 | 5369 |
| 4633 | 4700 | 4767 | 4834 | 4901 | 4968 | 5035 | 5102 | 5169 | 5236 | 5303 | 5370 |
| 4634 | 4701 | 4768 | 4835 | 4902 | 4969 | 5036 | 5103 | 5170 | 5237 | 5304 | 5371 |
| 4635 | 4702 | 4769 | 4836 | 4903 | 4970 | 5037 | 5104 | 5171 | 5238 | 5305 | 5372 |
| 4636 | 4703 | 4770 | 4837 | 4904 | 4971 | 5038 | 5105 | 5172 | 5239 | 5306 | 5373 |
| 4637 | 4704 | 4771 | 4838 | 4905 | 4972 | 5039 | 5106 | 5173 | 5240 | 5307 | 5374 |
| 4638 | 4705 | 4772 | 4839 | 4906 | 4973 | 5040 | 5107 | 5174 | 5241 | 5308 | 5375 |
| 4639 | 4706 | 4773 | 4840 | 4907 | 4974 | 5041 | 5108 | 5175 | 5242 | 5309 | 5376 |
| 4640 | 4707 | 4774 | 4841 | 4908 | 4975 | 5042 | 5109 | 5176 | 5243 | 5310 | 5377 |
| 4641 | 4708 | 4775 | 4842 | 4909 | 4976 | 5043 | 5110 | 5177 | 5244 | 5311 | 5378 |
| 4642 | 4709 | 4776 | 4843 | 4910 | 4977 | 5044 | 5111 | 5178 | 5245 | 5312 | 5379 |
| 4643 | 4710 | 4777 | 4844 | 4911 | 4978 | 5045 | 5112 | 5179 | 5246 | 5313 | 5380 |
| 4644 | 4711 | 4778 | 4845 | 4912 | 4979 | 5046 | 5113 | 5180 | 5247 | 5314 | 5381 |
| 4645 | 4712 | 4779 | 4846 | 4913 | 4980 | 5047 | 5114 | 5181 | 5248 | 5315 | 5382 |
| 4646 | 4713 | 4780 | 4847 | 4914 | 4981 | 5048 | 5115 | 5182 | 5249 | 5316 | 5383 |
| 4647 | 4714 | 4781 | 4848 | 4915 | 4982 | 5049 | 5116 | 5183 | 5250 | 5317 | 5384 |
| 4648 | 4715 | 4782 | 4849 | 4916 | 4983 | 5050 | 5117 | 5184 | 5251 | 5318 | 5385 |
| 4649 | 4716 | 4783 | 4850 | 4917 | 4984 | 5051 | 5118 | 5185 | 5252 | 5319 | 5386 |
| 4650 | 4717 | 4784 | 4851 | 4918 | 4985 | 5052 | 5119 | 5186 | 5253 | 5320 | 5387 |
| 4651 | 4718 | 4785 | 4852 | 4919 | 4986 | 5053 | 5120 | 5187 | 5254 | 5321 | 5388 |

(continued)

| | | | | | | | | | | | |
|---|---|---|---|---|---|---|---|---|---|---|---|
| 4652 | 4719 | 4786 | 4853 | 4920 | 4987 | 5054 | 5121 | 5188 | 5255 | 5322 | 5389 |
| 4653 | 4720 | 4787 | 4854 | 4921 | 4988 | 5055 | 5122 | 5189 | 5256 | 5323 | 5390 |
| 4654 | 4721 | 4788 | 4855 | 4922 | 4989 | 5056 | 5123 | 5190 | 5257 | 5324 | 5391 |
| 4655 | 4722 | 4789 | 4856 | 4923 | 4990 | 5057 | 5124 | 5191 | 5258 | 5325 | 5392 |
| 4656 | 4723 | 4790 | 4857 | 4924 | 4991 | 5058 | 5125 | 5192 | 5259 | 5326 | 5393 |
| 4657 | 4724 | 4791 | 4858 | 4925 | 4992 | 5059 | 5126 | 5193 | 5260 | 5327 | 5394 |
| 4658 | 4725 | 4792 | 4859 | 4926 | 4993 | 5060 | 5127 | 5194 | 5261 | 5328 | 5395 |
| 4659 | 4726 | 4793 | 4860 | 4927 | 4994 | 5061 | 5128 | 5195 | 5262 | 5329 | 5396 |
| 4660 | 4727 | 4794 | 4861 | 4928 | 4995 | 5062 | 5129 | 5196 | 5263 | 5330 | 5397 |
| 4661 | 4728 | 4795 | 4862 | 4929 | 4996 | 5063 | 5130 | 5197 | 5264 | 5331 | 5398 |
| 4662 | 4729 | 4796 | 4863 | 4930 | 4997 | 5064 | 5131 | 5198 | 5265 | 5332 | 5399 |
| 4663 | 4730 | 4797 | 4864 | 4931 | 4998 | 5065 | 5132 | 5199 | 5266 | 5333 | 5400 |
| 4664 | 4731 | 4798 | 4865 | 4932 | 4999 | 5066 | 5133 | 5200 | 5267 | 5334 | 5401 |
| 4665 | 4732 | 4799 | 4866 | 4933 | 5000 | 5067 | 5134 | 5201 | 5268 | 5335 | 5402 |
| 4666 | 4733 | 4800 | 4867 | 4934 | 5001 | 5068 | 5135 | 5202 | 5269 | 5336 | 5403 |
| 4667 | 4734 | 4801 | 4868 | 4935 | 5002 | 5069 | 5136 | 5203 | 5270 | 5337 | 5404 |
| 4668 | 4735 | 4802 | 4869 | 4936 | 5003 | 5070 | 5137 | 5204 | 5271 | 5338 | 5405 |
| 4669 | 4736 | 4803 | 4870 | 4937 | 5004 | 5071 | 5138 | 5205 | 5272 | 5339 | 5406 |
| 4670 | 4737 | 4804 | 4871 | 4938 | 5005 | 5072 | 5139 | 5206 | 5273 | 5340 | 5407 |
| 4671 | 4738 | 4805 | 4872 | 4939 | 5006 | 5073 | 5140 | 5207 | 5274 | 5341 | 5408 |
| 4672 | 4739 | 4806 | 4873 | 4940 | 5007 | 5074 | 5141 | 5208 | 5275 | 5342 | 5409 |
| 4673 | 4740 | 4807 | 4874 | 4941 | 5008 | 5075 | 5142 | 5209 | 5276 | 5343 | 5410 |
| 4674 | 4741 | 4808 | 4875 | 4942 | 5009 | 5076 | 5143 | 5210 | 5277 | 5344 | 5411 |
| 4675 | 4742 | 4809 | 4876 | 4943 | 5010 | 5077 | 5144 | 5211 | 5278 | 5345 | 5412 |
| 4676 | 4743 | 4810 | 4877 | 4944 | 5011 | 5078 | 5145 | 5212 | 5279 | 5346 | 5413 |
| 4677 | 4744 | 4811 | 4878 | 4945 | 5012 | 5079 | 5146 | 5213 | 5280 | 5347 | 5414 |
| 4678 | 4745 | 4812 | 4879 | 4946 | 5013 | 5080 | 5147 | 5214 | 5281 | 5348 | 5415 |
| 4679 | 4746 | 4813 | 4880 | 4947 | 5014 | 5081 | 5148 | 5215 | 5282 | 5349 | 5416 |
| 4680 | 4747 | 4814 | 4881 | 4948 | 5015 | 5082 | 5149 | 5216 | 5283 | 5350 | 5417 |
| 4681 | 4748 | 4815 | 4882 | 4949 | 5016 | 5083 | 5150 | 5217 | 5284 | 5351 | 5418 |
| 4682 | 4749 | 4816 | 4883 | 4950 | 5017 | 5084 | 5151 | 5218 | 5285 | 5352 | 5419 |
| 5420 | 5487 | 6656 | 6723 | 6790 | 6857 | 6924 | 6991 | 7058 | 7125 | | |
| 5421 | 5488 | 6657 | 6724 | 6791 | 6858 | 6925 | 6992 | 7059 | 7126 | | |
| 5422 | 5489 | 6658 | 6725 | 6792 | 6859 | 6926 | 6993 | 7060 | 7127 | | |
| 5423 | 5490 | 6659 | 6726 | 6793 | 6860 | 6927 | 6994 | 7061 | 7128 | | |
| 5424 | 5491 | 6660 | 6727 | 6794 | 6861 | 6928 | 6995 | 7062 | 7129 | | |
| 5425 | 5492 | 6661 | 6728 | 6795 | 6862 | 6929 | 6996 | 7063 | 7130 | | |
| 5426 | 5493 | 6662 | 6729 | 6796 | 6863 | 6930 | 6997 | 7064 | 7131 | | |
| 5427 | 5494 | 6663 | 6730 | 6797 | 6864 | 6931 | 6998 | 7065 | 7132 | | |
| 5428 | 5495 | 6664 | 6731 | 6798 | 6865 | 6932 | 6999 | 7066 | 7133 | | |
| 5429 | 5496 | 6665 | 6732 | 6799 | 6866 | 6933 | 7000 | 7067 | 7134 | | |
| 5430 | 5497 | 6666 | 6733 | 6800 | 6867 | 6934 | 7001 | 7068 | 7135 | | |
| 5431 | 5498 | 6667 | 6734 | 6801 | 6868 | 6935 | 7002 | 7069 | 7136 | | |
| 5432 | 5499 | 6668 | 6735 | 6802 | 6869 | 6936 | 7003 | 7070 | 7137 | | |
| 5433 | 5500 | 6669 | 6736 | 6803 | 6870 | 6937 | 7004 | 7071 | 7138 | | |
| 5434 | 5501 | 6670 | 6737 | 6804 | 6871 | 6938 | 7005 | 7072 | 7139 | | |
| 5435 | 5502 | 6671 | 6738 | 6805 | 6872 | 6939 | 7006 | 7073 | 7140 | | |
| 5436 | 5503 | 6672 | 6739 | 6806 | 6873 | 6940 | 7007 | 7074 | 7141 | | |
| 5437 | 5504 | 6673 | 6740 | 6807 | 6874 | 6941 | 7008 | 7075 | 7142 | | |
| 5438 | 5505 | **6674** | 6741 | 6808 | 6875 | 6942 | 7009 | 7076 | 7143 | | |
| 5439 | 5506 | 6675 | 6742 | 6809 | 6876 | 6943 | 7010 | 7077 | 7144 | | |

(continued)

| | | | | | | | | | | | |
|---|---|---|---|---|---|---|---|---|---|---|---|
| 5440 | 5507 | 6676 | 6743 | 6810 | 6877 | 6944 | 7011 | 7078 | 7145 | | |
| 5441 | 5508 | 6677 | 6744 | 6811 | 6878 | 6945 | 7012 | 7079 | 7146 | | |
| 5442 | 5509 | 6678 | 6745 | 6812 | 6879 | 6946 | 7013 | 7080 | 7147 | | |
| 5443 | 6612 | 6679 | 6746 | 6813 | 6880 | 6947 | 7014 | 7081 | 7148 | | |
| 5444 | 6613 | 6680 | 6747 | 6814 | 6881 | 6948 | 7015 | 7082 | 7149 | | |
| 5445 | 6614 | 6681 | 6748 | 6815 | 6882 | 6949 | 7016 | 7083 | 7150 | | |
| 5446 | 6615 | 6682 | 6749 | 6816 | 6883 | 6950 | 7017 | 7084 | 7151 | | |
| 5447 | 6616 | 6683 | 6750 | 6817 | 6884 | 6951 | 7018 | 7085 | 7152 | | |
| 5448 | 6617 | 6684 | 6751 | 6818 | 6995 | 6952 | 7019 | 7086 | 7153 | | |
| 5449 | 6618 | 6685 | 6752 | 6819 | 6886 | 6953 | 7020 | 7087 | 7154 | | |
| 5450 | 6619 | 6686 | 6753 | 6820 | 6887 | 6954 | 7021 | 7088 | 7155 | | |
| 5451 | 6620 | 6687 | 6754 | 6821 | 6888 | 6955 | 7022 | 7089 | 7156 | | |
| 5452 | 6621 | 6688 | 6755 | 6822 | 6889 | 6956 | 7023 | 7090 | 7157 | | |
| 5453 | 6622 | 6689 | 6756 | 6823 | 6890 | 6957 | 7024 | 7091 | 7158 | | |
| 5454 | 6623 | 6690 | 6757 | 6824 | 6891 | 6958 | 7025 | 7092 | 7159 | | |
| 5455 | 6624 | 6691 | 6758 | 6825 | 6892 | 6959 | 7026 | 7093 | 7160 | | |
| 5456 | 6625 | 6692 | 6759 | 6826 | 6893 | 6960 | 7027 | 7094 | 7161 | | |
| 5457 | 6626 | 6693 | 6760 | 6827 | 6894 | 6961 | 7028 | 7095 | 7162 | | |
| 5458 | 6627 | 6694 | 6761 | 6828 | 6895 | 6962 | 7029 | 7096 | 7163 | | |
| 5459 | 6628 | 6695 | 6762 | 6829 | 6896 | 6963 | 7030 | 7097 | 7164 | | |
| 5460 | 6629 | 6696 | 6763 | 6830 | 6897 | 6964 | 7031 | 7098 | 7165 | | |
| 5461 | 6630 | 6697 | 6764 | 6831 | 6898 | 6965 | 7032 | 7099 | 7166 | | |
| 5462 | 6631 | 6698 | 6765 | 6832 | 6899 | 6966 | 7033 | 7100 | 7167 | | |
| 5463 | 6632 | 6699 | 6766 | 6833 | 6900 | 6967 | 7034 | 7101 | 7168 | | |
| 5464 | 6633 | 6700 | 6767 | 6834 | 6901 | 6968 | 7035 | 7102 | 7169 | | |
| 5465 | 6634 | 6701 | 6768 | 6835 | 6902 | 6969 | 7036 | 7103 | 7170 | | |
| 5466 | 6635 | 6702 | 6769 | 6836 | 6903 | 6970 | 7037 | 7104 | 7171 | | |
| 5467 | 6636 | 6703 | 6770 | 6837 | 6904 | 6971 | 7038 | 7105 | 7172 | | |
| 5468 | 6637 | 6704 | 6771 | 6838 | 6905 | 6972 | 7039 | 7106 | 7173 | | |
| 5469 | 6638 | 6705 | 6772 | 6839 | 6906 | 6973 | 7040 | 7107 | 7174 | | |
| 5470 | 6639 | 6706 | 6773 | 6840 | 6907 | 6974 | 7041 | 7108 | 7175 | | |
| 5471 | 6640 | 6707 | 6774 | 6841 | 6908 | 6975 | 7042 | 7109 | 7176 | | |
| 5472 | 6641 | 6708 | 6775 | 6842 | 6909 | 6976 | 7043 | 7110 | 7177 | | |
| 5473 | 6642 | 6709 | 6776 | 6843 | 6910 | 6977 | 7044 | 7111 | 7178 | | |
| 5474 | 6643 | 6710 | 6777 | 6844 | 6911 | 6978 | 7045 | 7112 | 7179 | | |
| 5475 | 6644 | 6711 | 6778 | 6845 | 6912 | 6979 | 7046 | 7113 | 7180 | | |
| 5476 | 6645 | 6712 | 6779 | 6846 | 6913 | 6980 | 7047 | 7114 | 7181 | | |
| 5477 | 6646 | 6713 | 6780 | 6847 | 6914 | 6981 | 7048 | 7115 | 7182 | | |
| 5478 | 6647 | 6714 | 6781 | 6848 | 6915 | 6982 | 7049 | 7116 | 7183 | | |
| 5479 | 6648 | 6715 | 6782 | 6849 | 6916 | 6983 | 7050 | 7117 | 7184 | | |
| 5480 | 6649 | 6716 | 6783 | 6850 | 6917 | 6984 | 7051 | 7118 | | | |
| 5481 | 6650 | 6717 | 6784 | 6851 | 6918 | 6985 | 7052 | 7119 | | | |
| 5482 | 6651 | 6718 | 6785 | 6852 | 6919 | 6986 | 7053 | 7120 | | | |
| 5483 | 6652 | 6719 | 6786 | 6853 | 6920 | 6987 | 7054 | 7121 | | | |
| 5484 | 6653 | 6720 | 6787 | 6854 | 6921 | 6988 | 7055 | 7122 | | | |
| 5485 | 6654 | 6721 | 6788 | 6855 | 6922 | 6989 | 7056 | 7123 | | | |
| 5486 | 6655 | 6722 | 6789 | 6856 | 6923 | 6990 | 7057 | 7124 | | | |

**Claims**

1. A code sequence generator apparatus (303) for generating a plurality of spreading code sequences including a master spreading code sequence, the plurality of spreading code sequences having mutual cross correlation within a predetermined range, and having a predetermined mutual code phase relationship, comprising:

a clock generator means for generating a clock signal;

a linear feedback shift register LFSR (201), responsive to the clock signal and having a plurality of stages including a first stage and a last stage, each stage defining a respective tap, each tap producing a tap signal to a logic circuitry such that a predetermined group of the tap signals including the tap signal of the last stage are applied to the logic circuitry and the logic circuitry being adapted to combine the tap signals to produce a feedback spreading code signal, said feedback spreading code signal applied as an input signal to the first stage of the LFSR (201);

first memory means (223) for storing a plurality of spreading-code seeds, each spreading-code seed comprising a set of spreading-code sequence bit values, and said first memory being connected to the LFSR (201) and being responsive to a load signal for transferring each one of a predetermined set of the spreading-code sequence bit values of a selected one of the plurality of spreading-code seed into a respective one of the shift register stages of the LFSR; and

code generator controller means for selecting one of the plurality of spreading code seeds to determine the plurality of spreading code sequences and for providing the load signal indicating said one spreading-code seed,

wherein said LFSR (201) is responsive to the clock signal to sequentially transfer each respective tap signal from one stage to the next stage, from the first stage to the last stage and for transferring the feedback spreading code value to the first stage, and each successive one of the tap values of the last stage defines the master spreading code sequence, **characterized in that** the code sequence generator further comprises:

second memory means (222) being responsive to the clock signal for providing a repetitive even code sequence, said even code sequence having a cross correlation with the master spreading sequence which is within the predetermined range and having an even number of chip spreading values;

a plurality of cascade connected feedforward means (203), coupled to receive the master spreading code sequence, for providing a plurality of code sequences, each code sequence being a distinct spreading code sequence of said plurality of spreading code sequences, each of said feedforward means (203) being responsive to the clock signal, to provide a respective one of the plurality of spreading code sequences; and

a plurality code sequence combining means, each code sequence combining means for combining each respective spreading code sequence with said even code sequence to produce a plurality of relatively long spreading code sequences, each long spreading code sequence having a greater number of elements than any one of the plurality of spreading code sequences.

2. The code sequence generator apparatus of claim 1, wherein the plurality of cascade connected feedforward means (203) includes:

receiving means for receiving the master spreading sequence;

a feedforward circuit (202) having a plurality of cascade connected feedforward logic sections, each logic section defining a tap which provides one of the plurality of spreading code sequences, including a first feedforward logic section and a last feedforward logic section and connected sequentially from the first feedforward logic section to the last feedforward logic section, each feedforward logic section comprising a single delay element (211) having an input terminal which receives an input signal and an output terminal which provides an output signal, and logic combining means (220) for logically combining the input signal with the output signal to produce the respective spreading code sequence.

3. The code sequence generator apparatus claim 2, wherein the code sequence combining means comprises an EXCLUSIVE-OR logic circuit.

4. The code sequence generator apparatus of claim 2, wherein the logic combining means comprises an EXCLUSIVE-OR logic circuit for performing modulo-2 addition.

**Patentansprüche**

1. Codesequenzgeneratorvorrichtung (303) zum Erzeugen mehrerer Spreizcodesequenzen, einschließlich einer Master-Spreizcodesequenz, wobei die mehreren Spreizcodesequenzen eine gegenseitige Kreuzkorrelation innerhalb eines vorbestimmten Bereichs und ein vorbestimmtes gegenseitiges Phasenverhältnis haben, umfassend:

   - Taktgeneratormittel zum Erzeugen eines Taktsignals;
   - ein lineares Rückkopplungs-Schieberegister LFSR (201), das auf das Taktsignal anspricht und mehrere Stufen aufweist, mit einer ersten Stufe und einer letzten Stufe, wobei jede Stufe einen entsprechenden Abgriff ("Tap") definiert, wobei jeder Abgriff ein Abgriffsignal für eine Logikschaltung erzeugt, so dass eine vorbestimmte Gruppe von Abgriffsignalen, einschließlich des Abgriffsignals der letzten Stufe, an die Logikschaltung angelegt werden, und die Logikschaltung dazu ausgelegt ist, die Abgriffsignale zum Erzeugen eines Rückkopplungs-Spreizcodesignals zu kombinieren, wobei das Rückkopplungs-Spreizcodesignal als ein Eingangssignal an die erste Stufe des LFSR (201) angelegt wird;
   - erste Speichermittel (223) zum Speichern mehrerer Spreizcode-Startwerte ("Seeds"), wobei jeder Spreizcode-Startwert eine Menge von Spreizcodesequenzbitwerten umfasst und der erste Speicher mit dem LFSR (201) verbunden ist und auf ein Ladesignal zum Übertragen eines jeden einer vorbestimmten Menge der Spreizcodesequenzbitwerte eines Ausgewählten der mehreren Spreizcode-Startwerte in eine Entsprechende der Schieberegisterstufen des LFSR anspricht; und
   - Codegenerator-Controllermittel zum Auswählen eines der mehreren Spreizcode-Startwerte zum Bestimmen der mehreren Spreizcodesequenzen und zum Liefern des Ladesignals, das den einen Spreizcode-Startwert angibt,

   wobei das LFSR (201) auf das Taktsignal anspricht, um jedes entsprechende Abgriffsignal Stufe für Stufe von der ersten Stufe bis zur letzten Stufe zu übertragen und um den Rückkopplungs-Spreizcodewert an die erste Stufe zu übertragen, und jeder aufeinander Folgende der Abgriffswerte der letzten Stufe die Master-Spreizcodesequenz definiert, **dadurch gekennzeichnet, dass** der Codesequenzgenerator weiter umfasst:

   - zweite Speichermittel (222), die auf das Taktsignal ansprechen, um eine repetitive geradzahlige Codesequenz zu liefern, wobei die geradzahlige Codesequenz eine Kreuzkorrelation mit der Master-Spreizcodesequenz, die innerhalb des vorbestimmten Bereichs ist, und eine gerade Anzahl von Chip-Spreizwerten hat;
   - mehrere in einer Kaskade geschaltete Vorwärtsregelungsmittel (203), die zum Empfangen der Master-Spreizcodesequenz gekoppelt sind, zum Liefern mehrerer Codesequenzen, wobei jede Codesequenz eine eigene Spreizcodesequenz der mehreren Spreizcodesequenzen ist, wobei jedes der Vorwärtsregelungsmittel (203) auf das Taktsignal anspricht, um eine Entsprechende der mehreren Spreizcodesequenzen zu liefern; und
   - mehrere Codesequenzkombiniermittel, wobei jedes Codesequenzkombiniermittel zum Kombinieren einer jeden entsprechenden Spreizcodesequenz mit der geradzahligen Codesequenz ausgelegt ist, um mehrere relativ lange Spreizcodesequenzen zu erzeugen, wobei jede lange Spreizcodesequenz eine größere Anzahl von Elementen hat als eine der mehreren Spreizcodesequenzen.

2. Codesequenzgeneratorvorrichtung nach Anspruch 1, bei der die mehreren in einer Kaskade geschalteten Vorwärtsregelungsmittel (203) aufweisen:

   - Empfangsmittel zum Empfangen der Master-Spreizcodesequenz;
   - eine Vorwärtsregelungsschaltung (202), die mehrere in einer Kaskade geschaltete Vorwärtsregelungs-Logikabschnitte aufweist, wobei jeder Logikabschnitt einen Abgriff ("Tap") definiert, der eine der mehreren Spreizcodesequenzen liefert, und einen ersten Vorwärtsregelungs-Logikabschnitt und einen letzten Vorwärtsregelungs-Logikabschnitt aufweist, und sequentiell vom ersten zum letzten Vorwärtsregelungs-Logikabschnitt verbunden ist, wobei jeder Vorwärtsregelungs-Logikabschnitt ein einziges Verzögerungselement (211) umfasst, das einen Eingang, der ein Eingangssignal empfängt, und einen Ausgang aufweist, der ein Ausgangssignal liefert, sowie Logik-Kombiniermittel (220) zum logischen Kombinieren des Eingangssignals mit dem Ausgangssignal zum Erzeugen der entsprechenden Spreizcodesequenz.

3. Codesequenzgeneratorvorrichtung nach Anspruch 2, bei der die Codesequenzkombiniermittel eine EXKLUSIV-ODER-Logikschaltung umfassen.

4. Codesequenzgeneratorvorrichtung nach Anspruch 2, bei der die Logik-Kombiniermittel eine EXKLUSIV-ODER-Logikschaltung zum Durchführen einer Modulo-2-Addition umfassen.

**Revendications**

1. Appareil générateur de séquence de code (303) pour générer plusieurs séquences de code d'étalement comportant une séquence de code d'étalement maître, les diverses séquences de code d'étalement ayant une corrélation mutuelle croisée dans une plage prédéterminée, et ayant une relation mutuelle prédéterminée de phase de code, comprenant :

   un moyen de générateur d'horloge pour générer un signal d'horloge ;
   un registre à décalage bouclé sur lui-même LFSR (201), en réponse au signal d'horloge et ayant plusieurs étages comportant un premier étage et un dernier étage, chaque étage définissant une prise correspondante, chaque prise produisant une prise de signal vers un ensemble de circuits logiques de telle sorte qu'un groupe prédéterminé de prise de signaux comprenant la prise de signal du dernier étage soit appliqué aux circuits logiques et les circuits logiques étant adaptés pour combiner la prise de signaux pour produire une transmission en amont du signal de code d'étalement, ladite transmission en amont du signal de code d'étalement étant appliquée comme signal d'entrée au premier étage du LFSR (201) ;
   un premier moyen de mémoire (223) pour mémoriser plusieurs graines de code d'étalement, chaque graine de code d'étalement comprenant une série de valeurs de bit de séquence de code d'étalement, et chaque première mémoire étant reliée au LFSR (201) et réagissant à un signal de charge pour transférer chaque série prédéterminée des valeurs de bit de séquence de code d'étalement d'une graine sélectionnée parmi les diverses graines de code d'étalement dans un étage correspondant des étages du registre à décalage du LFSR ; et
   un moyen de commande de générateur de code pour choisir l'une des diverses graines de code d'étalement pour déterminer les diverses séquences de code d'étalement et pour fournir le signal de charge indiquant ladite graine de code d'étalement,

   où ledit LFSR (201) réagit au signal d'horloge pour transférer séquentiellement chaque prise de signal respective d'un étage à l'étage suivant, depuis le premier étage jusqu'au dernier étage, et pour transférer la valeur de code d'étalement de la transmission en amont au premier étage, et chacune des valeurs de prise successives du dernier étage définit la séquence de code d'étalement maître, **caractérisé en ce que** le générateur de séquence de code comprend de plus :

   un second moyen de mémoire (222) qui réagit au signal d'horloge pour fournir une séquence de code uniforme répétitive, ladite séquence de code uniforme ayant une corrélation croisée avec la séquence d'étalement maître qui se trouve dans la plage prédéterminée et ayant un même nombre de valeurs d'étalement de chip ;
   plusieurs moyens de transmission en aval en cascade (203), couplés pour recevoir la séquence de code d'étalement maître, pour fournir plusieurs séquences de code, chaque séquence de code étant une séquence distincte de code d'étalement desdites diverses séquences de code d'étalement, chacun desdits moyens de transmission en aval (203) réagissant au signal d'horloge, pour fournir une séquence respective des diverses séquences de code d'étalement ; et
   plusieurs moyens de combinaison des séquences de code, chaque moyen de combinaison de séquences de code combinant chaque séquence de code d'étalement respective avec ladite séquence de code uniforme pour produire plusieurs séquences de code d'étalement relativement longues, chaque séquence de code d'étalement longue ayant un plus grand nombre d'éléments que toute autre des diverses séquences de code d'étalement.

2. Appareil générateur de séquences de code selon la revendication 1, où les divers moyens de transmission en aval en cascade (203) comprennent :

   un moyen de réception pour recevoir la séquence d'étalement maître ;
   un circuit de transmission en aval (202) ayant plusieurs sections de logique de transmission en aval en cascade, chaque section logique définissant une prise de signal qui fourni l'une des diverses séquences de code d'étalement, comportant une première section logique de transmission en aval et une dernière section logique de transmission en aval et reliées séquentiellement de la première section logique de transmission en aval à la dernière section logique de transmission en aval, chaque section logique de transmission en aval comprenant un élément de retard unique (211) ayant une borne d'entrée qui reçoit un signal d'entrée et une borne de sortie qui fournit un signal de sortie, et un moyen de combinaison logique (220) pour combiner logiquement le signal d'entrée au signal de sortie pour produire la séquence de code d'étalement respective.

3. Appareil générateur de séquences de code selon la revendication 2, **caractérisé en ce que** le moyen de combinaison de séquences de code comprend un circuit logique OU EXCLUSIF.

4. Appareil générateur de séquences de code selon la revendication 2, **caractérisé en ce que** le moyen de combinaison logique comprend un circuit logique OU EXCLUSIF pour réaliser l'addition modulo-2.

## FIG. 1

## FIG. 2a

## FIG. 2c

## FIG. 2b

FIG.2d

FIG. 3a

FIG. 3b

FIG. 3c